(19) Europäisches Patentamt
European Patent Office
Office européen des brevets

(11) **EP 4 525 032 B1**

(12) **EUROPÄISCHE PATENTSCHRIFT**

(45) Veröffentlichungstag und Bekanntmachung des Hinweises auf die Patenterteilung:
**15.07.2026   Patentblatt 2026/29**

(21) Anmeldenummer: **24200207.9**

(22) Anmeldetag: **13.09.2024**

(51) Internationale Patentklassifikation (IPC):
***H10W 72/00*** *(2026.01)*

(52) Gemeinsame Patentklassifikation (CPC):
**H10W 72/073;** H10W 72/07125; H10W 72/07141;
H10W 72/07152

(54) **VORRICHTUNG ZUM VERBINDEN EINES BAUELEMENTS MIT EINEM SUBSTRAT**

DEVICE FOR CONNECTING A COMPONENT TO A SUBSTRATE

DISPOSITIF DE LIAISON D'UN COMPOSANT À UN SUBSTRAT

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität:  **15.09.2023  AT 507532023**

(43) Veröffentlichungstag der Anmeldung:
**19.03.2025   Patentblatt 2025/12**

(73) Patentinhaber: **SMT Maschinen- und Vertriebs GmbH & Co. KG**
**97877 Wertheim (DE)**

(72) Erfinder:
• **Ulzhöfer, Christian**
  **97877 Wertheim (DE)**
• **Eyrich, Tobias**
  **97877 Wertheim (DE)**

(74) Vertreter: **TBK**
**Bavariaring 4-6**
**80336 München (DE)**

(56) Entgegenhaltungen:
**US-A1- 2022 020 710**

**Beschreibung**

Die Erfindung betrifft eine Vorrichtung zum Verbinden eines Bauelements mit einem Substrat.

HINTERGRUND DER ERFINDUNG

Mit steigendem Bedarf der Elektronikindustrie an der Entwicklung effizienter und hochtemperaturbeständiger Bauelemente wie z. B. Chips, gewinnt das Sintern einer Verbindungsschicht zwischen Bauelement und Substrat an Popularität.

Sintern ist unter anderem als ein Verfahren zur Herstellung von Metallteilen oder Keramikteilen bekannt. Dabei entsteht durch Zusammenpressen eines pulverförmigen Ausgangsmaterials ein fein- oder grobkörniger Grünkörper, der bei einer anschließenden Temperaturbehandlung seine endgültige Form erhält und somit zu einem festen Werkstück wird.

Unter Sintern gemäß der Anmeldung und in der Herstellung und Verarbeitung von Bauelementen wie z. B. Halbleiter-Chips versteht man hier ein ähnliches Verfahren, ein Bauelement und ein Substrat unter Anwendung eines vorbestimmten Drucks und einer vorbestimmten Temperatur für eine gewisse Zeit zusammenzudrücken, wodurch eine Verbindung zwischen den beiden Elementen entsteht. Aktueller Stand der Technik ist der Einsatz von pastösen Materialien wie z. B. Silberoder Kupferpaste oder auch nanostrukturierten Plättchen, die als Verbindung zwischen Chip und Substrat dienen, und durch die Druck- und Temperaturbeaufschlagung versintert werden. Ein solches Sintern als Verfahren zum Verbinden eines Bauelements mit einem Substrat ist bekannt und hat sich als vorteilhaft gegenüber bisher angewendeten Lötverfahren auf Zinn-oder Bleibasis erwiesen.

Für einen derartigen Sintervorgang sind bestimmte Parameter wie z. B. eine Einstelltemperatur, ein Druck und eine Haltezeit für die effektive Befestigung des Bauelements auf dem Substrat zu definieren. Ausgehend von Versuchen können diese Parameter je nach Anforderung ermittelt werden. Bei solchen Sintervorgängen kann auch vorteilhaft ein Bindemittel eingesetzt werden, das zwischen dem Bauelement und dem Substrat aufgebracht wird. Entsprechend kann die Schichtdicke des Bindemittels einen weiteren Parameter darstellen. Bevorzugt kann eine Silberpaste als derartiges Bindemittel eingesetzt werden.

Bevorzugt kommt es während eines Sintervorgangs nicht zu einer Phasenumwandlung des Bindemittels, z. B. einer Silberpaste, wie es in den Lötverfahren auf Zinn- und Bleibasis der Fall ist. Durch geeignete Temperatur-und Druckanwendung wird bewirkt, dass Partikel des Bindemittels in die Oberfläche des Substrats und des zu befestigenden Bauelements diffundieren. Dadurch entsteht eine Verbindung von Oberfläche zu Oberfläche anstatt einer Phasenwechselverbindung.

Zu einer wirksamen Befestigung ist eine parallele, gleichmäßige Kraftverteilung auf der Oberfläche des Bauelements erforderlich, und eine solche ist zu gewährleisten. Daher ist eine individuelle Kraftaufbringungskomponente eine von modernen Elektronikherstellern bevorzugte Lösung, die eine gute Qualität der Verbindung gewährleisten kann. Individuelle Kraftaufbringung bedeutet ein separates Werkzeug für jede Paarung aus Bauelement und Substrat. Dies kann hohe Werkzeugkosten verursachen.

Die Anwendung von Temperatur und Druck ist erforderlich, um eine wirksame Verbindung zwischen dem Bauelement und dem Substrat zu erreichen, andernfalls könnte die Qualität der Verbindung schlecht oder für praktische Zwecke zu langsam sein.

Das Prinzip des Verfahrens besteht nicht in einer Phasenumwandlung des Verbindungsmittels (z. B. Silberpaste), wie es bei Lötverfahren auf Zinn- und Bleibasis der Fall ist. Durch geeignete Temperatur- und Druckanwendung diffundieren Silberbestandteile in die Oberfläche des Substrats und des zu befestigenden Bauelements. Dadurch wird der Kontakt zu einer Oberflächen-Oberflächen-Verbindung und nicht zu einem Phasenwechselkontakt.

Für diese Art von Prozess werden allgemein auch die Ausdrücke "die attach" oder "die packaging" verwendet.

Der Druckschrift US 2022/020710 A1 offenbart eine Vorrichtung zum Verbinden eines Bauelements mit einem Substrat.

Die Druckschrift DE 10 2013 101 124 zeigt eine Vorrichtung und ein Verfahren eines Sinterprodukts. Das Sinterprodukt umfasst ein Bauelement und ein Substrat. Um diese zu verbinden wird das Sinterprodukt in eine Vorrichtung mit einem Presstisch und einem Pressstempel eingelegt. Durch eine Temperaturerhöhung mittels einer Heizeinrichtung wird eine Ausdehnung eines Druckkörpers in dem Pressstempel bewirkt, wodurch auf das Sinterprodukt ein Druck ausgeübt wird. Somit wird das Bauelement mit dem Substrat verbunden. Die Druckschrift DE 10 2015 120 156 A1 offenbart eine Vorrichtung zur materialschlüssigen Verbindung von Verbindungspartnern eines Leistungselektronik-Bauteils. Hier wirkt ein formstabiler Rahmen auf einen der Verbindungspartner, während ein elastisches Kissen auf einen zweiten Verbindungspartner wirkt, um einen zum Verbinden erforderlichen Druck aufzubauen.

Um das zu sinternde Bauteil möglichst zu schonen, ist es wünschenswert, die Wärmezufuhr zu dem Bauteil während eines Sinterverfahrens möglichst genau einzustellen.

Es besteht Bedarf an einer Vorrichtung zum Verbinden eines Bauelements mit einem Substrat, die es ermöglichen, eine Wärmezufuhr zu einem zu sinternden Bauteil genau zu steuern.

Eine Vorrichtung zum Verbinden eines Bauelements mit einem Substrat gemäß der Erfindung ist mit einer in zumindest zwei Teile teilbaren Kammer versehen. An einem ersten Teil ist ein Stempel vorgesehen. An einem zweiten Teil ist ein Gegenstempel vorgesehen. An einer von dem ersten Teil abgewandten Seite des Gegenstempels ist eine Heizeinrichtung vorgesehen. Das erste Teil ist in Richtung des zweiten Teils verschiebbar, um die Kammer zu schließen. Der Gegenstempel ist in einem geöffneten Zustand der Kammer mit Ausgangsstoffen beschickbar und in einem geschlossenen Zustand der Kammer ist über den Stempel ein Druck auf die zwischen dem Stempel und dem Gegenstempel vorgesehenen Ausgangsstoffe ausübbar. In einem unbelasteten Zustand ist der Gegenstempel von der Heizeinrichtung beabstandet und ist konfiguriert, aufgrund des von dem Stempel ausgeübten Drucks gegen die Heizeinrichtung in Anlage zu geraten.

Da der Gegenstempel als Produkthalter von der Heizeinrichtung beabstandet ist, findet keine direkte Wärmeübertragung statt. Deswegen sind die Ausgangsstoffe auf dem Gegenstempel vor dem Beginn des Sintervorgangs noch keiner übermäßigen Wärmebelastung ausgesetzt. Erst mit Druckausübung durch den Stempel wird der Abstand zwischen dem Gegenstempel und der Heizeinrichtung überwunden und die Wärme daraufhin direkt auf den Gegenstempel, die Ausgangsstoffe und den Stempel übertragen.

Die Heizeinrichtung kann in Form einer Heizplatte ausgebildet sein, deren zu dem Gegenstempel gerichtete Oberfläche konfiguriert ist, flächig mit einer von dem ersten Teil abgewandten Oberfläche des Gegenstempels in Anlage zu geraten.

Durch die flächige Berührung der miteinander in Anlage befindlichen Oberflächen der Heizeinrichtung und des Gegenstempels ist eine schnelle und gleichmäßige Wärmeübertragung möglich.

Der Gegenstempel kann mittels Vorspannelementen von der Heizeinrichtung beabstandet sein, deren Vorspannung aufgrund des durch den Stempel ausgeübten Drucks überwunden wird. Nach Beendigung der Druckausübung durch den Stempel wird die Vorspannung wiederhergestellt.

Somit ist auch nach Beendigung des Sintervorgangs, sobald der Stempel zu einer Ausgangsstellung zurückgezogen wird, die direkte Wärmeübertragung unterbunden.

Der Gegenstempel kann in einem belastungsfreien Zustand mittels Federn von der Heizeinrichtung beabstandet sein.

Bevorzugt können hier Spiralfedern oder Blattfedern zum Einsatz kommen.

Der Gegenstempel kann in einem belastungsfreien Zustand mittels eines Luftkissens von der Heizeinrichtung beabstandet sein. Die Luftzufuhr zu dem Luftkissen kann über zumindest teilweise durch die Heizeinrichtung geführte Luftkanäle erfolgen.

Ein Luftkissen ist anstelle oder zusätzlich zu den Federn als Vorspannelement möglich. Durch die Luftzufuhr ist es außerdem möglich, die Wirkung der Erfindung zu verbessern. So kann nach dem Sintervorgang durch die Zufuhr von kalter Luft eine schnellere Abkühlung erreicht werden. Ebenfalls, kann vor dem Sintervorgang mittels heißer Luft bereits ein Vorwärmen des Gegenstempels erfolgen, falls dies erforderlich sein sollte.

Eine Vorrichtung zum Verbinden eines Bauelements mit einem Substrat gemäß der Erfindung ist mit einer in zumindest zwei Teile teilbaren Kammer versehen. An einem ersten Teil ist ein Stempel vorgesehen. An einem zweiten Teil ist ein Gegenstempel vorgesehen. An einer von dem ersten Teil abgewandten Seite des Gegenstempels ist eine Heizeinrichtung vorgesehen. Das erste Teil ist in Richtung des zweiten Teils verschiebbar, um die Kammer zu schließen. Der Gegenstempel ist in einem geöffneten Zustand der Kammer mit Ausgangsstoffen beschickbar und in einem geschlossenen Zustand der Kammer ist über den Stempel ein Druck auf die zwischen dem Stempel und dem Gegenstempel vorgesehenen Ausgangsstoffe ausübbar. Ein Schaft des Stempels ist in einer an dem ersten Teil vorgesehenen Stempelführungsplatte mittels Spielpassung mit Übermaß aufgenommen, und ein Druckkörper des Stempels weist eine größere Querschnittsfläche als der Schaft des Stempels auf. An einer von dem Gegenstempel abgewandten Seite der Stempelführungsplatte ist eine Unterdruckeinrichtung bereitgestellt.

Durch die Unterdruckeinrichtung ist es möglich, nach Beendigung eines Sintervorgangs durch Herstellen eines Unterdrucks den Stempel zurück in eine Ausgangsstellung zu saugen. Da der Druckkörper des Stempels eine größere Querschnittsfläche als der Schaft aufweist, ist verhindert, dass der Druckkörper dabei in die Stempelführungsplatte hineingezogen wird.

An der von dem Gegenstempel abgewandten Seite der Stempelführungsplatte kann eine Zylinderplatte bereitgestellt sein, die einen in einer Zylinderbohrung hin- und herbeweglichen Kolben aufweist. Der Kolben weist an einer zu dem Stempel gerichteten Seite eine Führungsstange auf, die konfiguriert ist, bei Druckbeaufschlagung des Kolbens gegen die Stirnfläche des Schafts in Anlage zu geraten und Druck auf den Stempel auszuüben.

Da die Führungsstange erst mit Betätigung des Kolbens gegen die Stirnfläche des Schafts des Stempels in Anlage gerät, ist in einer Ausgangsposition oder Rückzugsposition von Kolben und Stempel ein Abstand zwischen der Führungsstange und dem Schaft hergestellt. Somit ist eine Wärmeübertragung von dem Stempel auf die Führungsstange und den Kolben vermieden.

Die Stirnfläche des Schafts des Stempels kann plan sein und eine mit der Stirnfläche des Schafts in Anlage zu bringende Spitze der Führungsstange kann abgerundet sein.

Diese Struktur ermöglicht ein Kippen des Stempels bei möglicher nicht ebener Ausrichtung der Ausgangsstoffe, wodurch die Qualität des gesinterten Produkts verbessert wird.

Bei der Unterdruckeinrichtung kann es sich um eine zwischen der Stempelführungsplatte und einer an einer von dem Gegenstempel abgewandten Seite der Stempelführungsplatte vorgesehenen Zylinderplatte ausgebildete Zwischensteuerkammer handeln. Diese kann mit einem Unterdruck oder einem Überdruck beaufschlagt werden.

Die Ausgestaltung als Zwischensteuerkammer, die mit Überdruck oder Unterdruck beaufschlagt werden kann, hat den Vorteil, dass bei Feststecken eines Kolbens oder Stempels durch einen eingebrachten Überdruck die Beweglichkeit wieder hergestellt werden kann. Durch die Herstellung des Unterdrucks wird der Stempel zurück in seine Ausgangsposition oder Rückzugsposition gebracht.

Da der Kolben ebenfalls mittels Unterdruck aus einer anderen Unterdruckquelle in seine Rückzugsposition gebracht wird, besteht kein Risiko, dass der Kolben aufgrund des Überdrucks wieder ausfährt.

Im Folgenden werden noch weitere vorteilhafte Merkmale und Wirkungen der Erfindung beschrieben.

Die Erfindung schafft ein anpassungsfähiges Werkzeug zur Entwicklung einer Oberflächenmontagetechnologie durch Zusammenführen von Oberflächen aus verschiedenen Materialien durch einen Druck und eine bestimmte Temperatur, die auf die obere Oberfläche eines Bauelements wirken, durch einen formschlüssigen Dichtungs-/Verriegelungsmechanismus des Werkzeugs.

Es ist nicht erforderlich, eine Gegenkraft durch ein externes System bereitzustellen.

Das Werkzeug kann als abgedichtete Druckkammer ausgebildet sein (Unterdruck oder Überdruck). Der Verbindungsvorgang kann in einer Hochdruckgasoder Vakuumatmosphäre stattfinden. Die besagte Kammer ist durch die Form der Kammer selbst geschlossen. Ein Teil der Kammer - bevorzugt das untere Teil der Kammer - kann durch Antriebsmittel wie z.B. Motoren, oder z.B. durch hydraulische oder pneumatische Mittel in Position gebracht werden.

Die entstehende Druckkraft, die durch das Werkzeug ausgeübt wird, wird durch ein formschlüssiges mechanisches Innenelement und/oder eine geometrische Form ausgeglichen, so dass die Kraftreaktion einen kürzeren Weg nimmt.

Als Substrat kann eines aus direkt gebundenem Kupfer oder einem ähnlichen keramischen Substrat bestehen.

Der Druck kann mit z.B. 40 MPa vordefiniert sein. Der Verbindungsvorgang kann bei einer Temperatureinstellung zwischen z.B. 20°C und 330°C für eine definierte Zeit von z.B. 70-120 Sekunden stattfinden.

Die Temperatur kann durch eine Heizvorrichtung in der Kammer aufrechterhalten werden und bevorzugt direkt an den Stempeln bereitgestellt sein. Zusätzlich können vorteilhaft mehrere Heizvorrichtungen in dem System verwendet werden. Zur thermischen Isolierung von empfindlichen Bauteilen können Isolierschichten und/oder -materialien in der Kammer eingesetzt sein.

In dem Verbindungsvorgang kann zusätzlich eine Schutzfolie, z.B. aus PTFE-Material, zum Schutz der Halbleiterstempel eingesetzt sein, die bevorzugt mit Hilfe eines Walzenmechanismus angeordnet wird.

Die Kammer kann aus mehreren Teilen bestehen und für mehrere Bauelemente (Chips) in Form von mehreren Ebenen vorgesehen sein. Es kann auch eine gleichzeitige Bearbeitung auf einer Ebene oder auf verschiedenen, übereinander angeordneten Ebenen vorgenommen werden.

Die Größe des Stempels, insbesondere von dessen zu der Gegenfläche gerichteten Fläche, kann exakt der Größe des Bauelements (Chip) entsprechen.

KURZE BESCHREIBUNG DER FIGUREN

Weitere Vorteile der Erfindung werden auch aus der folgenden Beschreibung anhand der Figuren deutlich, die ein derzeit bevorzugtes Ausführungsbeispiel zeigen.

Fig. 1 zeigt eine erfindungsgemäße Vorrichtung zum Verbinden eines Bauelements mit einem Substrat in einem geöffneten Zustand.

Fig. 2a zeigt eine Seitenansicht eines Formschlussmechanismus der Vorrichtung, und Fig. 2b zeigt eine Schnittansicht der Fig. 2a.

Fig. 3a zeigt eine Schnittansicht des Formschlussmechanismus in einem geschlossenen Zustand der Vorrichtung unter Last, und Fig. 3b zeigt eine Schnittansicht gemäß Fig. 3a in einem geschlossenen Zustand der Vorrichtung ohne Belastung.

Fig. 4a zeigt eine Modifikation gemäß Fig. 3a, die mit einer Dichtung versehen ist, und Fig. 4b zeigt die Modifikation gemäß Fig. 4b.

Fig. 5 zeigt eine Alternative eines Formschlussmechanismus.

Fig. 6 zeigt ein Detail eines Stempels zum Verbinden eines Bauelements mit einem Substrat.

Fig. 7a zeigt eine Ansicht eines Stempels von einer Unterseite des Stempels aus betrachtet, Fig. 7b zeigt eine seitliche Ansicht des Stempels, dessen Schaft in einer Stempelführungsplatte geführt ist, und Fig. 7c zeigt eine Ansicht des in der Stempelführungsplatte geführten Stempelschafts von einer Oberseite aus betrachtet.

Fig. 8 zeigt eine Detailansicht eines Unterteils der Vorrichtung mit einer Einrichtung zur thermischen Trennung.

Fig. 9 zeigt eine Alternative einer Einrichtung zur thermischen Trennung.

Fig. 10 zeigt eine perspektivische Ansicht einer additiv gefertigten Zylinderplatte.

Fig. 11 zeigt eine Vorderansicht der Zylinderplatte der Fig. 10.

Fig. 12 zeigt eine Schnittansicht der Zylinderplatte der Fig. 10 entlang der Linie A-A in der Fig. 11.

Fig. 13 zeigt eine perspektivische Ansicht einer modifizierten, additiv gefertigten Zylinderplatte.

Fig. 14 zeigt eine perspektivische Ansicht einer weiteren modifizierten, additivgefertigten Zylinderplatte.

Fig. 15 zeigt eine perspektivische Ansicht einer mehrteiligen Zylinderplatte und einer Stempelplatte gemäß einer Ausführungsform der Erfindung.

Fig. 16 zeigt eine Vorderansicht der Zylinderplatte mit Stempelplatte gemäß Fig. 15.

Fig. 17 zeigt eine Draufsicht auf die Zylinderplatte der Fig. 15.

Fig. 18 zeigt eine Draufsicht auf eine Stempelplatte entsprechend der Linie A-A der Fig. 16.

Fig. 19 zeigt eine perspektivische Anordnung einer geteilten Zylinderplatte, einer Stempelplatte und eines Gegenstempels gemäß einer Ausführungsform der Erfindung.

Fig. 20 zeigt eine Ansicht der Anordnung der Fig. 19 von vorne.

Fig. 21 zeigt eine Ansicht auf die Zylinderplatte der Fig. 19 von der Stempelplatte aus gesehen entsprechend der Linie D-D in der Fig. 20.

Fig. 22 zeigt eine Schnittansicht der Anordnung der Fig. 19.

Fig. 23 zeigt eine perspektivische Ansicht einer alternativen Ausführungsform einer Anordnung einer geteilten Zylinderplatt und darunter angeordneter Stempelplatte.

Fig. 24 zeigt eine Ansicht der Anordnung der Fig. 23 von vorne.

Fig. 25 zeigt eine Draufsicht auf die Zylinderplatte der Anordnung der Fig. 23.

Fig. 26 zeigt eine Draufsicht auf die Stempelplatte der Anordnung der Fig. 23 entsprechend der Linie A-A in der Fig. 24.

Fig. 27 zeigt eine Draufsicht einer alternativen Ausführungsform einer geteilten Zylinderplatte.

Fig. 28 zeigt eine Draufsicht einer alternativen Ausführungsform einer Stempelplatte.

Fig. 29 zeigt eine Draufsicht auf einen erfindungsgemäßen Gegenstempel.

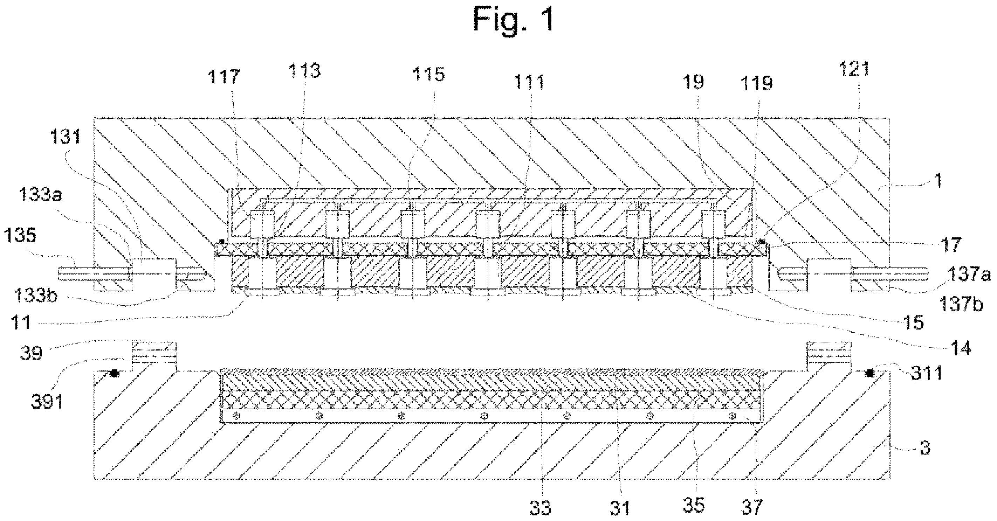

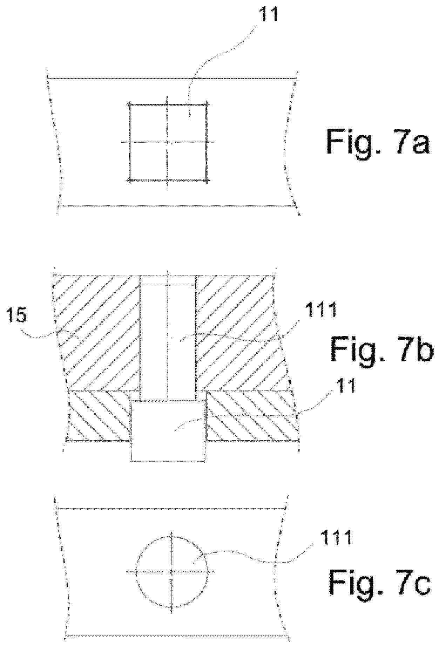

Ausführungsformen der Erfindung werden anhand der Figuren 1 bis 29 beschrieben. Bei den Figuren handelt es sich um schematische Figuren, und es können beschriebene Details weggelassen sein.

Die erfindungsgemäße Vorrichtung ist mit Bezug auf die Fig. 1 in Form einer Kammer ausgebildet, die ein Oberteil 1 (erstes Teil) und ein Unterteil 3 (zweites Teil) hat. Die Kammer hat im Wesentlichen die Form eines hohlen Quaders mit vier Seitenwänden, Boden und Deckelwand. Durch Trennen des Unterteils 3 von dem Oberteil 1 kann die Kammer in zwei Teile geöffnet werden, deren Öffnungen zueinander gerichtet sind.

In dem Unterteil 3 ist eine auch als Produkthalter bezeichnete Pressplatte 31 vorgesehen, die eine Funktion eines Gegenstempels übernimmt. Die Pressplatte 31 dient dazu, vor einem Sintervorgang Ausgangsstoffe wie ein Substrat, eine Sinterpaste und ein Bauelement anzuordnen. Unterhalb von der Pressplatte 31 ist eine Heizplatte (Heizeinrichtung) 33 angeordnet. Die Heizplatte 33 dient dazu, während eines Sintervorgangs Wärme an die Pressplatte 31 abzugeben und diese dabei aufzuwärmen.

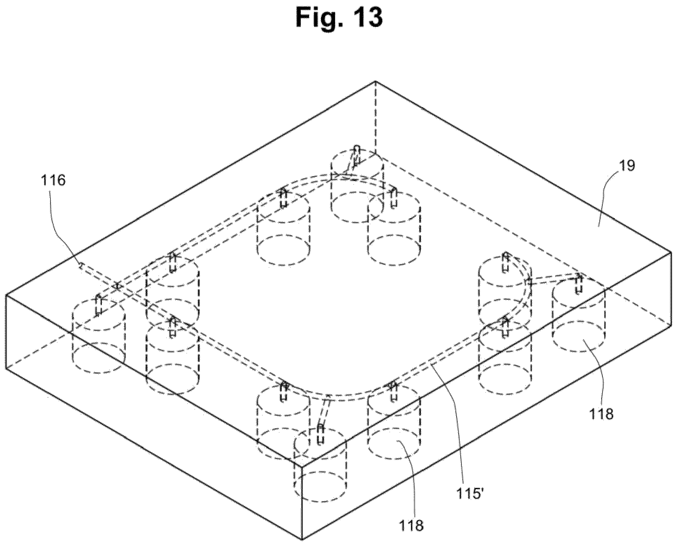

Das Oberteil wird anhand der Figuren 1, 6 und 7 genauer beschrieben. An dem Oberteil 1 der Kammer ist an einer obersten Position, d. h. eine Position die am weitesten von der Öffnung des Oberteils 1 entfernt liegt, eine Zylinderplatte 19 vorgesehen. Die Zylinderplatte 19 ist additiv gefertigt und weist Zylinderbohrungen 118, 118a, 118b, 118c auf, in denen Kolben 117 aufgenommen sind. Die Zylinderbohrungen 118, 118a, 118b, 118c an einer von dem jeweiligen Kolben 117 abgewandten Seite der Zylinderplatte 19 sind mit einer Druckzufuhrleitung 115, 115', 115a, 115b, 115c in Verbindung. Diese Kolben-Zylinderanordnung dient als eine pneumatische Verstellungseinrichtung. Beispiele für unterschiedliche Anordnungen einer oder mehrerer Druckzufuhrleitungen sind aus den Figuren 13 bis 18 und 21 bis 23 ersichtlich und im Zusammenhang mit der erfindungsgemäßen Zylinderplatte 19 weiter oben beschrieben.

Zur Betätigung der Kolben 117 wird über die Druckzufuhrleitung 115, 115', 115a, 115b, 115c ein mit Druck beaufschlagtes Fluid wie z. B. Luft in die Zylinderbohrungen 118, 118a, 118b, 118c in der Zylinderplatte 19 eingebracht, wodurch die Kolben 117 betätigt werden. Durch die Betätigung bewegen sich die Kolben 117 zusammen mit einer an einer zu dem Unterteil 3 gerichteten Seite des Kolbens 117 vorgesehenen Führungsstange 113 in Richtung des Unterteils 3 der Kammer. Diese Richtung wird im Folgenden auch als "Richtung nach unten" oder einfach "nach unten" bezeichnet und entspricht in den Figuren einer Richtung von der Blattoberseite zu der Blattunterseite.

Während es bevorzugt ist, alle Kolben gleichzeitig durch Beaufschlagen des Fluids in der Druckzufuhrleitung mit einem vorgegebenen Druck zu betätigen, ist es alternativ möglich, Mittel vorzusehen, um die Kolben 117 einzeln anzusteuern. Eine Rückstellung der Kolben 117 erfolgt durch Anlegen eines Unterdrucks in der Druckzufuhrleitung 115, 115', 115a, 115b, 115c, wodurch die Kolben 117 mit den Führungsstangen 113 in ihre Ausgangsposition zurückgeführt werden.

Jeder Kolben 117 kann über die Führungsstange 113 mit einem Schaft 111 eines Stempels in Anlage gebracht werden. Dies erfolgt, indem ein abgerundetes, von dem Kolben 117 abgewandtes Ende der Führungsstange 113 durch die Betätigung des Kolbens 117 nach unten gegen eine zu dem Kolben 117 gerichtete, eben ausgebildete Stirnfläche des Schafts 111 geführt wird.

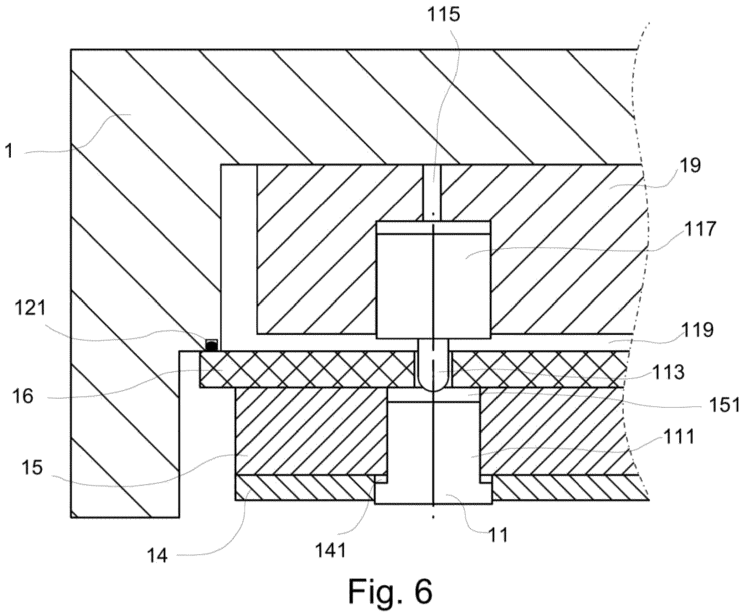

Wie insbesondere aus der Fig. 6 ersichtlich ist, ist die Führungsstange 113 dabei durch ein Loch in einer oberhalb einer Stempelführungsplatte 15 angeordneten Oberplatte 16 geführt. Die Oberplatte 16 ist außerdem mit den Innenwänden des Oberteils 1 derart in Anlage, dass ein zwischen der Oberplatte 16 und der Zylinderplatte 19 vorhandener Raum unabhängig von dem Druck in der Druckzufuhrleitung 115, 115', 115a, 115b, 115c mit einem Überdruck oder Unterdruck beaufschlagt werden kann. Bevorzugt ist dazu zwischen den Innenwänden des Oberteils 1 und der Oberplatte 16 eine Dichtung 8 vorgesehen. Der Raum zwischen der Oberplatte 16 und der Zylinderplatte 19 ist als Zwischensteuerraum 119 bezeichnet.

Der Schaft 111 des Stempels ist zylindrisch ausgebildet und durch ein Loch in einer Stempelführungsplatte 15 geführt. Der Durchmesser des Lochs ist dabei so bemessen, dass er den Durchmesser des Schafts 111 des Stempels geringfügig überschreitet, d. h. es liegt hier eine Spielpassung mit Übermaß vor. Das Spaltmaß beträgt zwischen 8 und 12 $\mu$m. Ein Spaltmaß von 10 $\mu$m ist dabei bevorzugt.

An der von dem von dem Kolben abgewandten Seite des Schafts 111 befindet sich ein Druckkörper 11 des Stempels, der zu der Pressplatte 31 gerichtet ist. In der Fig. 1 sind sieben Stempel dargestellt, allerdings ist die Zahl der Stempel in keinster Weise beschränkt, sondern kann beliebig gewählt sein. Insbesondere kann auch nur ein einziger Stempel vorgesehen sein, obwohl eine größere Anzahl an Stempeln bevorzugt ist.

Jeder Stempel ist aus einem Teil gefertigt und besteht aus dem Schaft 111 und dem Druckkörper 11. Der zylindrische Schaft 111 ist durch die Stempelführungsplatte 15 geführt und kann aufgrund der Spielpassung mit Übermaß zu einem geringen Ausmaß gekippt werden. Hier kann das maximal mögliche Ausmaß des Kippens durch das genaue Spaltmaß zwischen Schaft 111 und dem Loch durch die Stempelführungsplatte 15 eingestellt werden.

Das Kippen wird dadurch ermöglicht, dass die Führungsstange 113 ein abgerundetes Ende aufweist, das auf der zu dem Kolben 117 gerichteten planen Stirnfläche des Schafts 111 abrollen kann. Dadurch, dass der Schaft 111 und damit der Stempel 11 kippen können, ist es möglich, eine Schräglage der zu sinternden Bauelemente auszugleichen. Das heißt, dass der Stempel bei Heranführen an ein nicht exakt eben ausgerichtetes Bauelement in der Lage ist, sich durch Kippen an die Schräge des Bauelements anzupassen.

Der Druckkörper 11 des Stempels ist quaderförmig ausgebildet. Seine Fläche an der von dem Kolben abgewandten Unterseite wird als Druckfläche bezeichnet. Die Abmessungen der Druckfläche übersteigen geringfügig die des zu sinternden Produkts, um bei kleinen Lageabweichungen wie z. B. einer geringfügigen Verdrehung des Stempels und damit des Druckkörpers 11 das zu sinternde Bauteil dennoch zuverlässig vollständig abzudecken.

Der Druckkörper 11 des Stempels ist in einer Ausnehmung 141 aufgenommen, die an einer Unterseite einer unterhalb der Stempelführungsplatte 15 vorgesehenen Stempelunterplatte 14, vorgesehen ist. Die Dicke der Stempelunterplatte 14 und damit der Ausnehmung 141 ist so bemessen, dass es dem Druckkörper 11 des Stempels während einer Druckbeaufschlagung durch die Kolben 117 nicht möglich ist, vollständig aus der Ausnehmung herauszugeraten. Die Gesamthöhe der Ausgangsstoffe und damit der erforderliche Verfahrweg des Stempels bewegen sich nämlich im Mikrometerbereich, während die Höhe des Druckkörpers und auch der Ausnehmung einige Millimeter beträgt.

Ein Abstand zwischen den Seiten des Druckkörpers 11 und den Innenwänden der Ausnehmung 141 ist dabei größer bemessen als der Abstand zwischen dem Schaft 111 und der Innenwand des Lochs. Aus diesem Grund ist ausgeschlossen, dass es durch das voranstehend beschriebene, mögliche Kippen des Stempels zu einem Verklemmen des Druckkörpers 11 in der Ausnehmung 141 kommt.

Da der Stempel mit der Führungsstange 113 bzw. dem Kolben 117 lediglich in Anlage gerät, aber nicht fest damit verbunden ist, verbleibt der Stempel nach einer Druckbeaufschlagung in einer ausgefahrenen Position, obwohl der Kolben 117 und die Führungsstange 113 durch Beaufschlagen der Druckzufuhrleitung mit einem Unterdruck wieder in ihre Ausgangsposition zurückgeführt werden. Dieser Zustand ist schematisch in der Fig. 6 gezeigt.

Um den Stempel von dem gesinterten Produkt zu lösen und in seine Ausgangsposition zurückzuführen, wird der Zwischensteuerraum 119 mit einem Unterdruck beaufschlagt und der Stempel aufgrund des nun vorherrschenden Druckunterschieds zwischen dem Bereich des Druckkörpers 11 und dem Zwischensteuerraum zurück in seine Ausgangsposition gesaugt. Dabei entsteht allerdings eine geringe Luftströmung zwischen dem Schaft 111 und der Innenwand des Lochs sowie zwischen den Wänden des Druckkörpers 11 und den Innenwänden der Ausnehmung 141.

Diese geringe Luftströmung ist allerdings vernachlässigbar klein und wird beendet, sobald die den Schaft 111 umgebende obere Fläche des Druckkörpers 11 gegen die Stempelführungsplatte 15 gerät. Da der Druckkörper 11 des Stempels mit seiner oberen Fläche in Anlage gegen die Unterseite der Stempelführungsplatte 15 gerät, ist verhindert, dass die Stirnfläche des Schafts 111 gegen die Führungsstange 113 des zurückgezogenen Kolbens 117 stößt. Dies hat den Vorteil, dass es zu einer thermischen Trennung zwischen dem nach dem Sinterprozess heißen Stempel und dem Kolben kommt.

Einen Beitrag zur Rückstellung des Stempels liefert dabei auch ein aus einem Zwischenraum 151 zwischen der Stirnseite des Schafts 111 und der Oberplatte 16 gesaugte Luft, wie aus Fig. 6 ersichtlich ist. In dem Zwischenraum 151 vorhandene Luft wird nämlich bereits einerseits durch das Rückstellen der Führungsstange 113 durch das Herstellen des Unterdrucks in der Zwischensteuerkammer 119 verstärkt.

Aufgrund dieser Ausgestaltung ist es möglich, einen defekten Stempel jederzeit ohne großen Aufwand auszutauschen oder abhängig vom zu sinternden Bauteil einen vollständigen Austausch aller Stempel vorzunehmen. Hierzu ist es lediglich erforderlich, den Stempel nach unten zu entnehmen und gegen andere Stempel auszutauschen.

Sollte es trotz der thermischen Trennung zu einem Verklemmen des Kolbens 117 kommen und dieser lediglich aufgrund des Unterdrucks in der Druckzufuhrleitung 115, 115', 115a, 115b, 115c nicht zurückgezogen werden können, kann durch eine Druckerhöhung in dem Zwischensteuerraum 119 ein Druck auf die Unterseite des Kolbens ausgeübt werden, wodurch sich die Verklemmung lösen und der Kolben 117 in die Ausgangsposition zurückfahren kann.

Hier sei noch erwähnt, dass aufgrund von unterschiedlichen Querschnitten des Kolbens 117 und des Stempels mit der Druckfläche des Druckkörpers 11 ein Mindestverhältnis von durch den Kolben 117 auf die Führungsstange 113 und den Schaft 111 ausgeübten Eingangsdruck zu dem Ausgangsdruck der Stempelfläche einzuhalten ist. Der Eingangsdruck wird auf einen kreisförmigen Querschnitt des Kolbens 117 aufgebracht.

Bei einer möglichen Ausbildung des Stempels mit der Druckfläche in einer quadratischen Form sei die Seitenlänge des Quadrats "a". Der Kolben 117 weist in beiden Fällen einen kreisförmigen Querschnitt mit einem Radius "a" auf. In diesem Fall, in dem der Querschnitt der Stempelfläche quadratisch ist, ist das Verhältnis von Eingangs- zu Ausgangsfläche am kleinsten. Das heißt, der auf das Bauelement ausgeübte Druck wird maximal, wie sich aus der Gleichung

$$P = F / A$$

ergibt. In der Gleichung steht "P" für den Druck, "F" für die Kraft und "A" für die die Querschnittsfläche.

Bei einer Seitenlänge des Quadrats "a" beträgt das Verhältnis von Druckfläche zu Kolbenfläche ca. 1,273. Dies entspricht dem Verhältnis der Fläche eines Quadrats mit der Seitenlänge "a" zu der eines in das Quadrat eingeschriebenen Kreises mit dem Durchmesser "a".

Somit ist es erforderlich, den Kolben 117 mit einem Druck zu beaufschlagen, der höher als der auf die Ausgangsstoffe ausgeübte Druck ist. In dem obigen Beispiel müsste der Eingangsdruck ca. 51 MPa betragen, damit ein gewünschter Abgabedruck von 40 MPa vorherrscht.

In dem Fall einer nicht quadratischen, sondern z. B. rechteckigen Druckfläche ist das Verhältnis analog zu ermitteln. Erforderliche Eingangsdrücke für unterschiedliche Stempelflächen können z. B. in Form einer Tabelle oder für unterschiedliche Abgabedrücke in Form eines Kennfelds bereitgestellt sein. Details des Unterteils 3 werden insbesondere anhand der Figuren 1, 8 und 9 genauer beschrieben.

An dem Unterteil 3 der Kammer sind in einer Reihenfolge von unten nach oben eine Kühlplatte 37, eine thermische Isolierung in Form einer Isolierplatte 35, eine Heizplatte 33 und ein Produkthalter 31 vorgesehen. Der Produkthalter 31 dient als Gegenstempel und dient dazu, ein Substrat zu tragen, auf welches Bauelemente zu sintern sind.

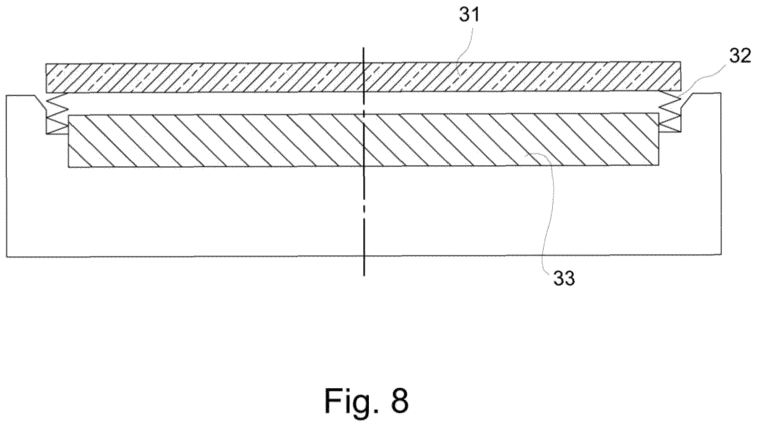

Um die Qualität des gesinterten Erzeugnisses zu verbessern, ist es erforderlich, eine Wärmezufuhr zu den Ausgangsstoffen möglichst zeitgleich mit der Druckausübung durch den Stempel vorzunehmen. Hierzu ist eine thermische Trennung zwischen der Heizplatte 33 und dem darüber vorgesehenen Produkthalter 31 vorgesehen, wie aus der Fig. 8 schematisch ersichtlich ist.

Um die thermische Trennung herbeizuführen, sind zwischen einer Unterseite des Produkthalters 31 und einer Bodenwand des Unterteils 3 Vorspannelemente 32 vorgesehen, die den Produkthalter 31 von der Heizplatte 33 beabstandet nach oben vorspannen. Die Vorspannelemente 32 können in Form von Federn wie z. B. Spiralfedern ausgeführt sein, wie in der Fig. 8 schematisch dargestellt ist, sind aber nicht darauf beschränkt.

Beispielsweise sind anstelle der schematisch angedeuteten Spiralfedern andere Arten von Federn wie Blattfedern, Hydraulik- oder Pneumatikkolben oder mechanische Mittel wie Zahnstangen als Vorspannelemente möglich.

Aufgrund der Vorspannelemente 32 befindet sich der Produkthalter 31 in einer von der Heizplatte 33 beabstandeten Position, in der eine Wärmeübertragung höchstens in reduzierter Weise stattfindet, da sich ein Luftspalt als Isolator zwischen dem Produkthalter 31 und der Heizplatte 33 befindet. Sobald die Stempel betätigt werden und beginnen, einen Druck auf die Ausgangsstoffe und den diese tragenden Produkthalter auszuüben, wird die Vorspannkraft der Vorspannelemente 32 überwunden und der Produkthalter 31 in Anlage mit der Heizplatte 33 gebracht. In diesem Zustand kommt es zu einer direkten Wärmeübertragung von der Heizplatte 33 zu dem Produkthalter 31 und weiter auf die Ausgangsstoffe.

Somit sind die Ausgangsstoffe zeitgleich dem Druck und der Wärme ausgesetzt, bis die Druckbelastung durch den Stempel durch Zurückstellen des Kolbens 117 beendet wird. Zeitgleich mit dem Beenden der Druckbelastung, wird wiederum durch die Vorspannkraft der Vorspannelemente 32 der Produkthalter 31 von der Heizplatte 33 entfernt, sodass ein weiteres Erwärmen des Produkthalters 31 und der Ausgangsstoffe durch die noch immer heiße Heizplatte 33 unterbleibt.

Es sei darauf hingewiesen, dass die Darstellung der Fig. 8 lediglich die für die thermische Trennung wichtigen Bauteile zeigt, der Gesamtaufbau aber so ausgeführt sein kann, wie in der Fig. 1 dargestellt ist. Zum Beispiel kann zwischen der Heizplatte 33 und der Bodenwand des Unterteils 3 eine thermische Isolierung, eine Kühlung usw. vorhanden sein.

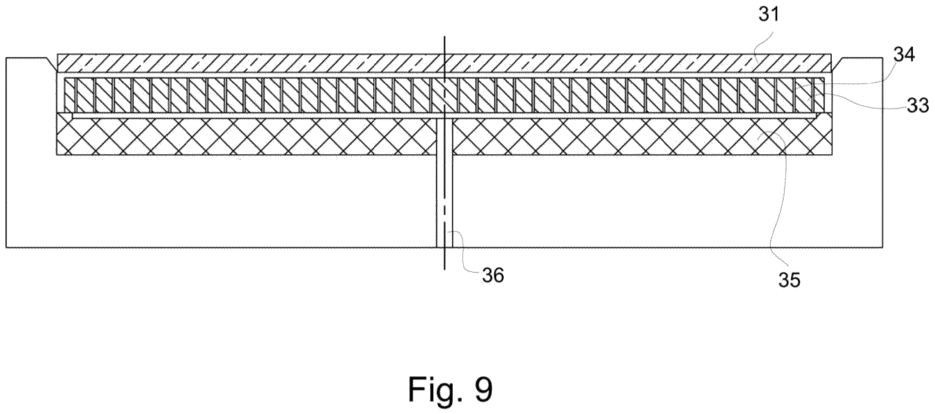

Die Fig. 9 zeigt in schematischer Weise eine Alternative zur thermischen Trennung von Produkthalter und Heizplatte. Gemäß der Alternative ist die Heizplatte mit einer Vielzahl von ihrer Unterseite zu ihrer Oberseite gerichteten Durchgangslöchern (Luftkanälen) versehen, die mit einem durch die Bodenwand des Unterteils 3 und die thermische Isolierung 35 der Heizplatte 33 führenden Luftzufuhrkanal 36 in Verbindung sind. Um den Produkthalter 31 thermisch von der Heizplatte 33 zu trennen, wird bis zur Aktivierung des Drucks durch den Kolben 117 auf den Stempel Luft oder ein anderes geeignetes Fluid durch den Luftzufuhrkanal 36 zugeführt. Nachdem diese Luft durch die vielen Luftkanäle in der Heizplatte 33 durchgegangen ist, bildet sie zwischen der Heizplatte 33 und dem Produkthalter ein Luftkissen, das neben einer thermischen Trennung für eine zusätzliche Isolierung gegen Strahlungswärme sorgt.

Durch Unterbrechen der Luftzufuhr zum Zeitpunkt der Druckbetätigung des Kolbens 117 wird das Luftkissen zwischen der Heizplatte 33 und dem Produkthalter 31 beseitigt. Der Produkthalter 31 gerät gegen die Heizplatte in Anlage und erfährt somit eine sofortige Erwärmung. Diese Wärme wird zeitgleich auf die dann unter Druck durch den Stempel stehenden Ausgangsstoffe übertragen.

Zur Durchführung des Sinterprozesses wird die Vorrichtung geschlossen, indem das Oberteil 1 und das Unterteil 3 zusammengeführt werden. Dieser Vorgang wird insbesondere anhand der Figuren 1 bis 5 beschrieben.

Die Seitenwände des Oberteils 1 weisen an ihrem zu dem Unterteil 3 gerichteten Rand eine Ausnehmung 131 auf. Neben der Ausnehmung 131 befinden sich entsprechende Vorsprünge 137a und 137b. Die Seitenwände des Unterteils 3 weisen einen entsprechenden Vorsprung 39 auf, der zwischen den Vorsprüngen 137a und 137b in die Ausnehmung 131 eingeführt wird, wenn der Rand des Oberteils 1 mit dem Rand des Unterteils 3 in Anlage gebracht wird. Zusätzlich ist außerhalb des Vorsprungs 39 des Unterteils 3 eine Dichtung angeordnet, die mit dem Schließen der Kammer deren Innenraum fluiddicht gegenüber der äußeren Umgebung abdichtet.

In jedem der Vorsprünge 137a, 137b, 39 sind quer zu einer Öffnungs- bzw. Schließrichtung der Kammer Löcher 133a, 133b und 391 vorgesehen, deren Querschnitte in dem in Anlage befindlichen Zustand, d. h. bei geschlossener Kammer, einander überlappen. Die Löcher 133a, 133b und 391 sind in Form von Langlöchern ausgeführt. Dies bedeutet, dass eine Länge $l_1$ der Löcher 133a, 133b des Oberteils und eine Länge $l_2$ des Lochs 391 in dem Unterteil 3 eine Breite b der Löcher 133a, 133b und 391 übersteigt. Bei dem innerhalb liegenden Loch 133b handelt es sich um ein Sackloch.

In den Figuren sind die Proportionen der Löcher in übertriebener Weise dargestellt. Tatsächlich ist es ausreichend, wenn die Längen $l_1$ und $l_2$ die Breiten b der der Löcher 133a, 133b und 391 um ca. 0,5 mm übersteigen.

Die Löcher können beispielsweise in Abhängigkeit ihrer Anzahl einen Durchmesser von 5 bis 40 mm aufweisen. Derselbe Durchmesserbereich trifft für den Stift, bzw. die Stifte zu. Dabei sind Toleranzen von H7 bis 2mm möglich. Wenn die Löcher größer als die Stifte gewählt werden, ergibt sich über den oberen Druckpunkt (d. h., wo der Stift mit der Wand des Lochs in Berührung gerät) in vorteilhafter Weise eine automatische Zentrierung, wodurch hochpräzise Passungen gar nicht erforderlich sind.

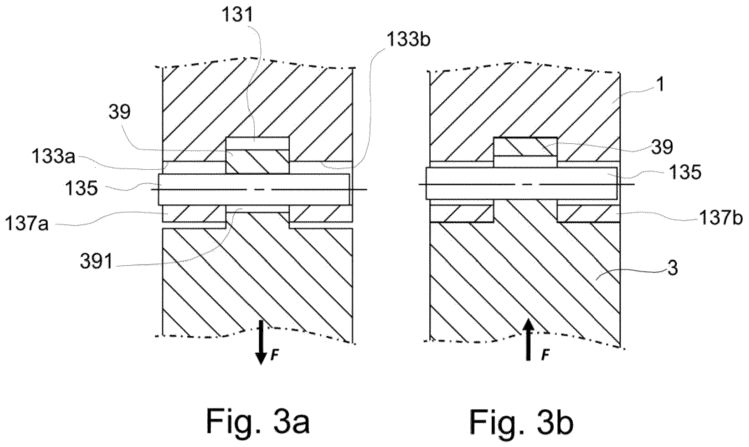

Wegen der Proportionen der Löcher 133a, 133b und 391, kann ein zylindrischer Stift 135 in dem in Anlage befindlichen Zustand aufgrund des durch die Langlochform geschaffenen Spiels einfach durch alle Löcher geführt werden. Sobald der Kolben 117 eine Druckbelastung auf den Stempel und über diesen auf das Unterteil 3 der Kammer ausübt, stellt sich eine Situation gemäß der in Fig. 3a dargestellten ein.

Aufgrund der Druckbelastung wirkt eine Kraft F nach unten, wodurch sich das Unterteil 3 der Kammer aus dem in Anlage befindlichen Zustand so weit nach unten verschiebt, bis eine weitere Verschiebung aufgrund des nun blockierenden Stifts 135 nicht mehr möglich ist. Somit ist es durch diesen Formschluss möglich, die auf das Unterteil wirkende Kraft aufzunehmen, ohne dass aufwändige Hydrauliktische etc. vorgesehen werden müssen.

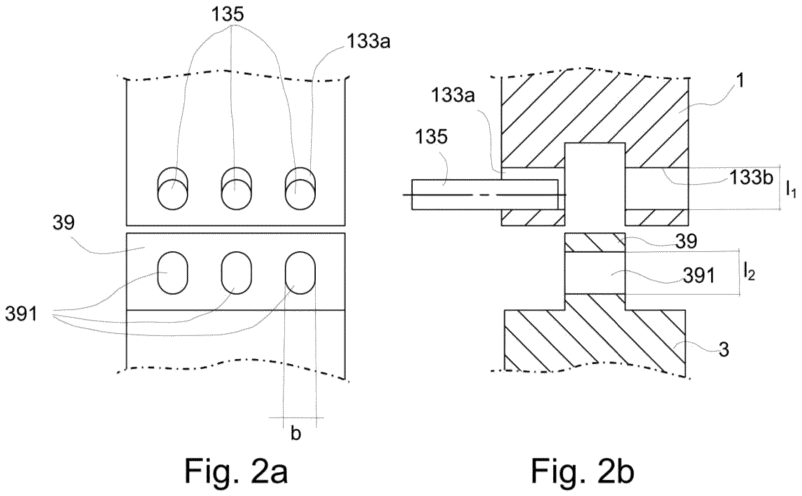

Wie aus der Fig. 2a ersichtlich ist, sind mehrere Serien der Löcher 133a, 133b und 391 vorgesehen, auf die die entstehende Kraft F aufgeteilt wird. Somit können Anforderungen hinsichtlich der Materialkennwerte der Stifte herabgesetzt werden.

Nach dem Verriegeln der Kammer wird der Stempel betätigt, deren Druck auf die Ausgangsstoffe wirkt. Daher entsteht auf die auf dem Produkthalter 31 abgelegten Ausgangsstoffe, wie zum Beispiel ein Substrat, eine Schicht einer Silberpaste als Verbindungsmittel und ein Chip als Bauelement, ein vorbestimmter Druck auf die Ausgangsstoffe. Erfindungsgemäß kann ein Druck von 40 bis 50 MPa erreicht werden.

In der Kammer kann in dem Bereich zwischen dem Produkthalter 31 und der Stempelunterplatte 14 eine Temperatur zwischen 20 °C und 330 °C erreicht werden. Dadurch ist es möglich, einen Verbindungsvorgang zwischen 70 und 120 Sekunden abzuschließen. Vorteilhaft ist hier, dass die Heizplatte so angeordnet ist, dass die Wärme direkt zu dem Produkthalter 31 abgegeben wird.

Die Herstellung des erforderlichen Drucks erfolgt durch Beaufschlagen von Kolben 117 in Zylindern der Zylinderplatte 19 mit einem unter hohem Druck stehenden Gas.

Falls erforderlich, kann außerdem in der Kammer durch Einleiten von Gas bzw. Entnehmen davon ein Überdruck oder Unterdruck hergestellt werden und/oder ein Gas wie zum Beispiel Stickstoff zur Förderung des Verbindungsvorgangs oder ein Reaktionsgas zugeführt werden.

Bei Halten dieses Zustands für eine vorgegebene Zeit kommt es zu einem Sintervorgang, d. h. einer Verbindung der Silbermoleküle mit dem Bauelement und dem Substrat.

Sobald die Druckbelastung auf den Stempel endet, kann das Unterteil 3 wieder gegen das Oberteil 1 in Anlage geraten, wie aus der Fig. 3b ersichtlich ist. In diesem Zustand kann der Stift 135 wieder einfach aus den Löchern 133a, 133b und 391 entnommen und die Kammer geöffnet werden, um die fertig gesinterten Bauelemente zu entnehmen.

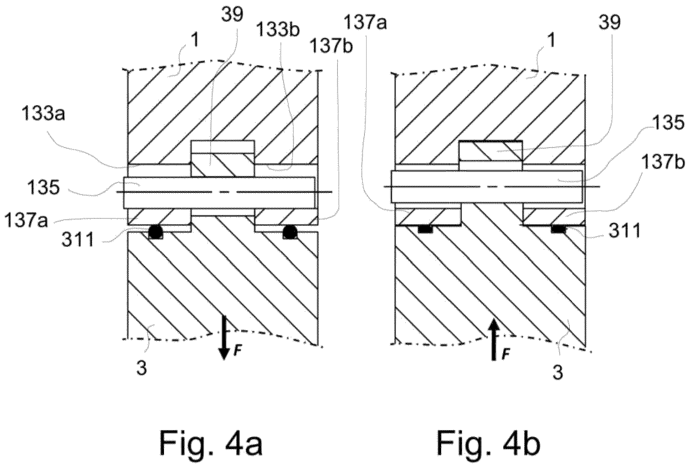

In den Figuren 4a und 4b ist eine Variante gezeigt, in der zusätzlich Dichtungen 311 innerhalb und außerhalb des Vorsprungs 39 vorgesehen sind. Diese Dichtungen 311 sind in der Lage, das Innere der Kammer nicht nur in dem in Anlage befindlichen Zustand (siehe Fig. 4b), sondern auch in dem Druckbelastungszustand (siehe Fig. 4a) fluiddicht abzudichten.

Sämtliche während des Sintervorgangs entstehende Druckkräfte werden aufgrund des Formschlusses durch die Kammer selbst aufgenommen. Daher ist es nicht erforderlich, weitergehende strukturelle Maßnahmen zur Aufnahme oder Ableitung von hohen Druckkräften zu ergreifen.

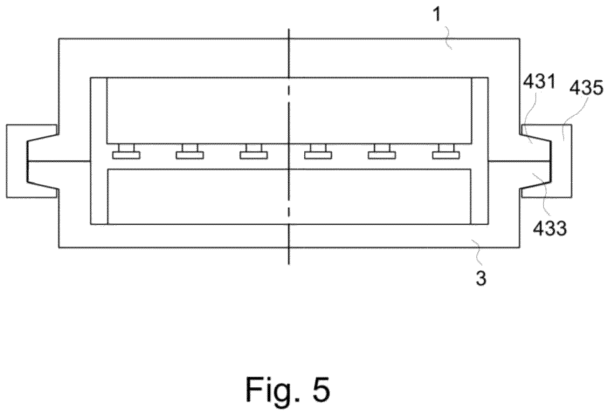

Eine Alternative zur Ausgestaltung des Formschlusses ist schematisch aus der Fig. 5 ersichtlich. Hier ist anstelle der oben beschriebenen Ausgestaltung jede Seitenwand des Oberteils 1 und des Unterteils 3 mit einem flanschartigen Vorsprung 431, 433 versehen. Die Vorsprünge 431, 433 weisen an ihren voneinander weg gerichteten Flächen eine Schräge auf. Zur Herstellung des Formschlusses wird eine C-förmige Klammer 435 über die Vorsprünge geführt. Die Klammer 435 weist an ihren zu den schrägen Flächen der Vorsprünge gerichteten Schenkelinnenflächen eine korrespondierende Schräge auf, sodass eine flächige Berührung zwischen den Schenkelinnenflächen der Klammer 435 und den schrägen Flächen der Vorsprünge 431, 433 möglich ist. Im Fall der hier beschriebenen Alternative werden die Druckkräfte von der C-förmigen Klammer 435 aufgenommen, die nach Beendigung des Sintervorgangs aufgrund der Schrägen wieder einfach entfernt werden kann.

Anstatt des oben beschrieben zylindrischen Stifts, kann der Formschluss z. B. auch mit Kegelstiften und entsprechend kegelförmigen Bohrungen realisiert werden.

Vorteilhaft kann dieser oben beschriebene Prozess automatisiert erfolgen.

Gemäß Stand der Technik müssen die aufgrund des Pressvorgangs erforderlichen Gegenkräfte mittels externer Strukturen aufgebracht werden. Dort sorgt ein Mechanismus, mit dem eine Trägerbaugruppe zum Halten des Substrats nach oben bewegt wird, für eine externe Kraft, die erforderlich ist, um das Substrat in seiner Position zu arretieren und die für den Prozess erforderliche Gegenkraft zu erzeugen. Dies führt jedoch zu einer Maschinenstruktur, die schwer und sehr komplex ist.

Aufgrund des erfindungsgemäßen Formschlusses schafft die vorliegende Erfindung einen internen Gegenkraftmechanismus. Daher ist eine externe Kraftquelle zur Bereitstellung der Gegenkraft nicht erforderlich.

Zur Vorbereitung des Verbindungsverfahrens wird die Paste auf das Substrat gedruckt und die Bauelemente (Chips) werden auf der Paste angeordnet, d. h. das Substrat wird mit den Chips auf der Paste bestückt. Danach wird das bedruckte und mit Chips bestückte Substrat in die Kammer eingebracht.

Da das Werkzeug anpassbar ist, entsprechen die Positionen des Stempels nämlich den entsprechenden Positionen der Chips auf dem Substrat. Vorteilhaft kann eine Folie z. B. über an den Seiten des Werkzeugs angebrachte Walzen über die Chips platziert werden. Die Folie kann nach jedem Verbindungsvorgang erneuert werden. Dies kann durch Erneuern der Walzen mit der Folie oder durch verändern der Position der vorhandenen Folie vorgenommen werden. Letzteres kann durch Weiterziehen der auf einer Walze aufgewickelten Folie vorgenommen werden, und dabei die Position der Folie geändert werden. Als Folienwerkstoff kann z. B. PTFE oder ein ähnlicher Kunststoff zum Einsatz kommen, ist aber nicht darauf beschränkt.

Der Verbindungsvorgang läuft über einen vorbestimmten Zeitraum bei einer vorbestimmten Temperatur und einem vorbestimmten Druck ab, um das Bauelement wirkungsvoll auf das Substrat zu sintern. Vorteilhaft können vor und nach dem Verbindungsvorgang das Bauelement und/oder die anderen Ausgangsstoffe wie Substrat und Silberpaste durch eine Vorheiz- bzw. Kühlvorrichtung vorgewärmt oder abgekühlt werden.

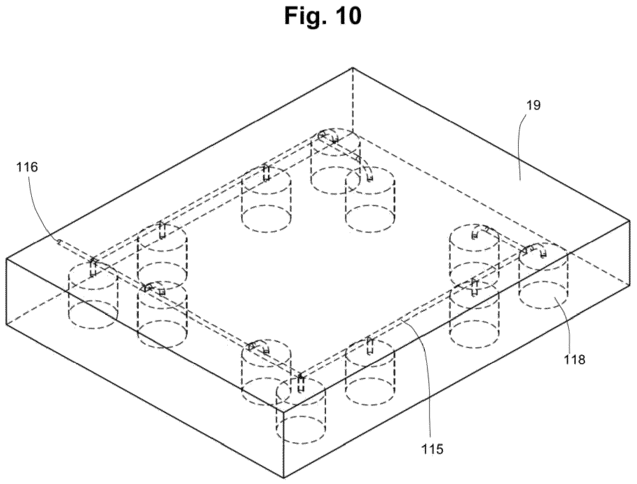

Im Folgenden werden insbesondere die Zylinderplatte 19 gemäß der Erfindung sowie die Anordnung der Zylinderplatte 19, der Stempelplatte 15 und des Gegenstempels 31 der erfindungsgemäßen Vorrichtung zum Verbinden eines Bauelements mit einem Substrat in größerem Detail anhand der Figuren 10 bis 29 beschrieben.

Es sei noch darauf hingewiesen, dass in den Figuren zur besseren Übersichtlichkeit nicht jedes Element mit Bezugzeichen versehen ist. Zum Beispiel ist in der Fig. 10 nur eine Zylinderbohrung mit dem Bezugszeichen 118 versehen. Die übrigen Zylinderbohrungen sind aber, abgesehen von ihrer Position, gleichartig wie die mit dem Bezugszeichen versehene Zylinderbohrung.

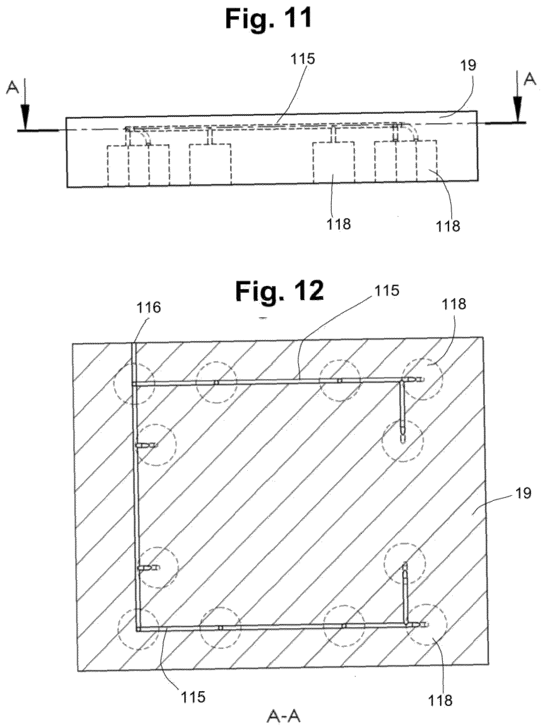

Die Zylinderplatte 19 in den Figuren 10 bis 14 ist durch additive Fertigung hergestellt. Dazu wird ein flüssiges Material schichtweise auf eine Arbeitsfläche aufgetragen. Nach dem Auftragen verfestigt sich das flüssige Material, sodass weitere Schichten auf die bereits vorhandenen verfestigten Materialschichten aufgetragen werden können. Das Auftragen findet derart statt, dass Bereiche ausgespart bleiben, die in der fertigen Zylinderplatte nicht mit Material versehen sind. Dabei handelt es sich insbesondere um Zylinderbohrungen 118 und eine Druckzufuhrleitung 115. Wie z. B. aus der Figur 10 ersichtlich ist, ist die Druckzufuhrleitung 115 von einem Anschluss 116 an der Seite der Zylinderplatte 19 zu den Zylinderbohrungen 118 geführt. Die Figur 11 zeigt eine Vorderansicht der Zylinderplatte der Figur 10 und die Figur 12 zeigt eine Schnittansicht der Zylinderplatte der Figur 10 entlang der Linie A-A in der Figur 11.

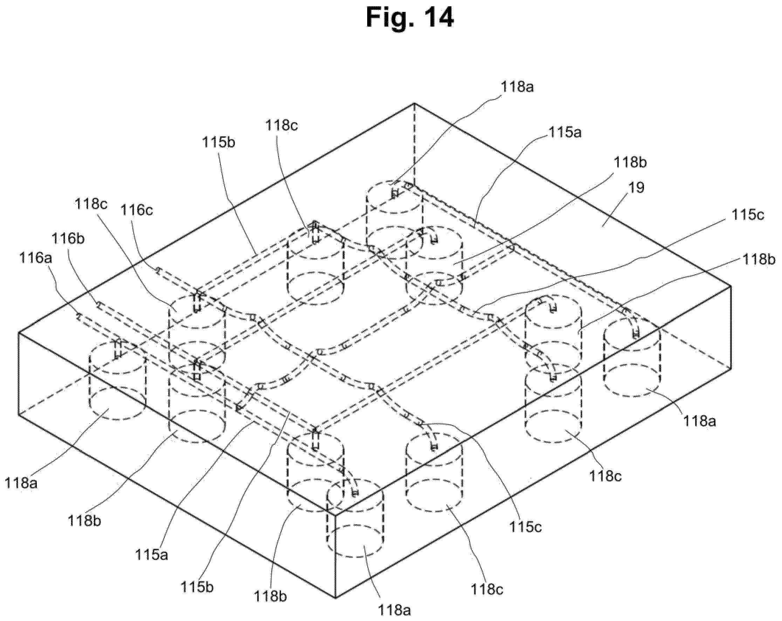

Aus den Figuren 13 und 14 sind weitere Ausgestaltungen von additiv gefertigten Zylinderplatten ersichtlich.

In Figur 13 ist eine Druckzufuhrleitung 115' abweichend zu der geradlinigen Gestaltung der Figuren 10 bis 12 in einer gekrümmten Weise ausgeführt. Dadurch verringert sich das durch die Druckzufuhrleitung 115' eingenommene Volumen in der Zylinderplatte 19, wodurch die Festigkeit der Zylinderplatte 19 abermals verbessert wird.

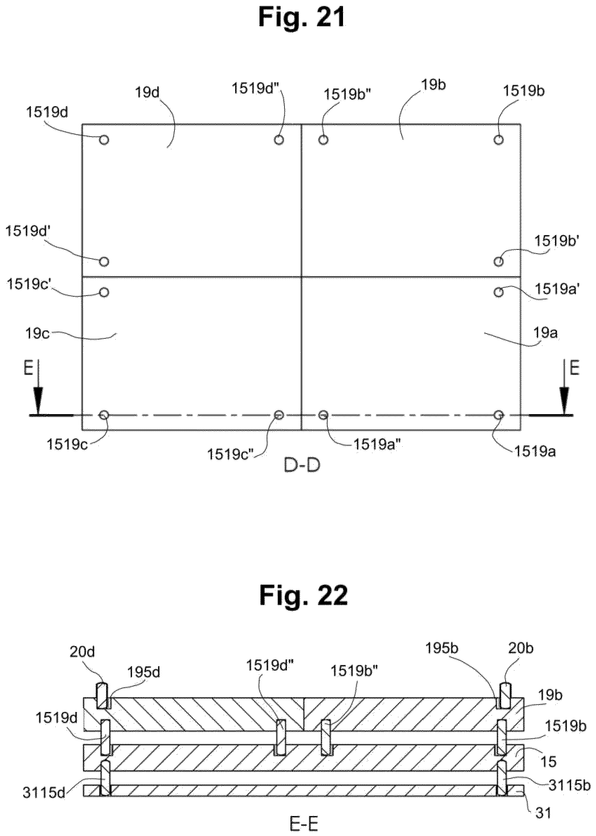

In der Figur 14 sind die Zylinderbohrungen in drei Gruppen von Zylinderbohrungen 118a, 118b 118c aufgeteilt. Jede dieser einzelnen Gruppen wird durch eine eigene Druckzufuhrleitung 115a, 115b oder 115c, von Anschlüssen 116a, 116b, 116c mit einem Druckmedium versorgt. Die Druckzufuhrleitungen 115a, 115b und 115c liegen alle in derselben Ebene. Lediglich bei Kreuzungspunkten und Schnittpunkten von zwei Leitungen wie zum Beispiel der Leitung 115a mit der Leitung 115b ist eine der Druckzufuhrleitungen über die andere geführt. Aus der Figur 21 ist gezeigt, dass z. B. die Druckzufuhrleitung 115a sowohl über die Druckzufuhrleitung 115b wie auch über die Druckzufuhrleitung 115c geführt ist, um die von dem Anschluss entfernten Zylinderbohrungen 118a, 118a in der Figur in der Zeichnung oben und rechts zu versorgen. In ähnlicher Weise ist die Druckzufuhrleitung 115c an Kreuzungen mit der Druckzufuhrleitung 115b über diese geführt.

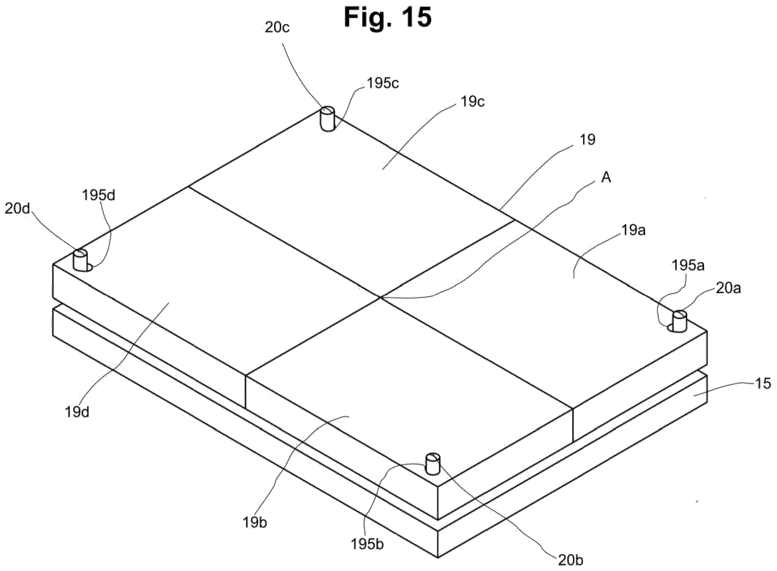

Figuren 15 bis 29 zeigen Ausführungsformen der Zylinderplatte 19 gemäß der Erfindung bzw. Anordnungen der Zylinderplatte 19, der Stempelplatte 15 und des Gegenstempels 31 in einer Vorrichtung zum Verbinden eines Bauelements mit einem Substrat.

In den Figuren 15 bis 29 sind die Zylinderplatte 19, die Stempelplatte 15 und der Gegenstempel 31 lediglich mit Merkmalen zum Ausgleich einer Wärmedehnung dargestellt, während andere Details wie z. B. die Druckzufuhrleitungen, die Zylinder, die Stempel usw. nicht dargestellt sind.

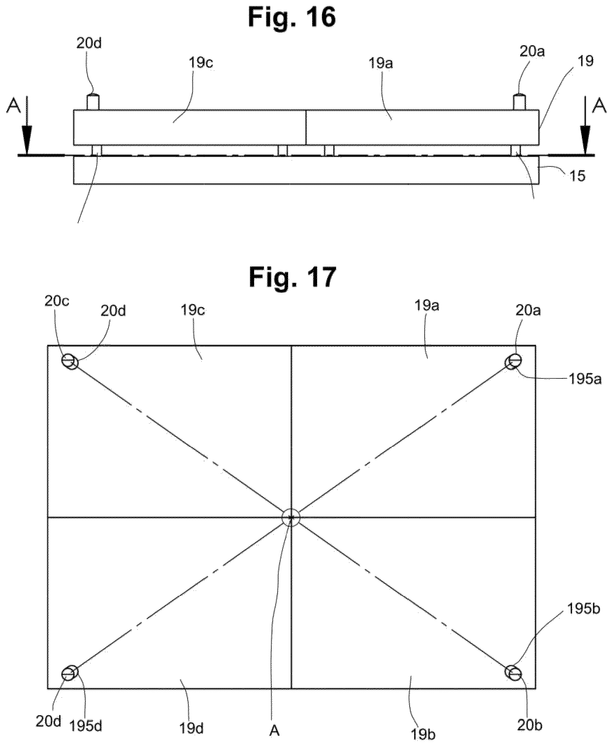

Figur 15 zeigt eine perspektivische Ansicht einer mehrteiligen Zylinderplatte und einer Stempelplatte gemäß einer Ausführungsform der Erfindung. Figur 16 zeigt eine Vorderansicht der Zylinderplatte mit Stempelplatte gemäß Figur 15. Figur 17 zeigt eine Draufsicht auf die Zylinderplatte der Figur 15.

Die Zylinderplatte 19 ist mehrteilig aus vier Teilen 19a, 19b, 19c und 19d ausgeführt. Jedes Teil 19a, 19b, 19c, 19d weist eine Form eines Rechtecks auf. Alle vier Teile 19a, 19b, 19c, 19d sind so angeordnet, dass sie in einem Stoßpunkt A aneinander anliegen. Der Stoßpunkt A entspricht dabei in dieser Ausführungsform dem Mittelpunkt der Zylinderplatte 19 und auch einem Nullpunkt.

Zur Verbindung mit einem Oberteil einer Vorrichtung zum Verbinden eines Bauelements mit einem Substrat sind Stifte 20a, 20b, 20c, 20d vorgesehen, die in an den Ecken der Zylinderplatte 19 vorgesehenen Löchern 195a, 195b, 195c, 195d aufgenommen sind. Die Löcher 195a, 195b, 195c, 195d sind als Langlöcher ausgeführt, deren Längsachse auf einer Linie liegt, die die jeweilige Ecke der Zylinderplatte 19 bzw. des jeweiligen Teils 19a, 19b, 19c, 19d mit dem Stoßpunkt A verbindet. Somit schneiden sich die Längsachsen der Langlöcher in dem Stoßpunkt A, der in diesem Ausführungsbeispiel auch dem Nullpunkt entspricht. Die Stifte 20a, 20b, 20c, 20d sind dabei an dem Oberteil der Vorrichtung zum Verbinden eines Bauelements mit einem Substrat fixiert und ragen in die Langlöcher 195a, 195b, 195c, 195d der Zylinderplatte 19. Aus diesem Grund kann die Zylinderplatte 19 einfach in Richtung nach unten entfernt werden, wenn die Kammer geöffnet ist.

Diese Anordnung bewirkt, dass im Fall einer Erwärmung der Zylinderplatte 19, der Nullpunkt (Stoßpunkt A) an Ort und Stelle verbleibt, während die äußeren Ecken der Zylinderplatte 19 oder jedes Teils 19a, 19b, 19c, 19d entlang der Achse des entsprechenden Langlochs 195a, 195b, 195c, 195d mit dem jeweiligen Stift 20a, 20b, als Führung aufgrund einer Wärmedehnung verschoben werden können.

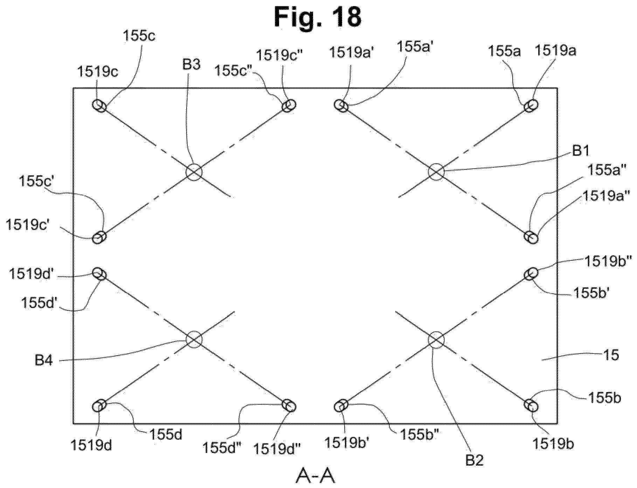

Zur Kompensation einer Wärmedehnung der Stempelführungsplatte 15 ist diese ebenfalls mit Langlöchern 155a, 155a' und 155a", 155b, 155b' und 155b", 155c, 155c' und 155c", 155d, 155d' und 155d" versehen, wie aus der Figur 18 ersichtlich ist. Darüber hinaus ist die Stempelplatte 15 über Stifte 1519a, 1519a', 1519a", 1519b, 1519b', 1519b", 1519c, 1519c', 1519c", 1519d, 1519d', 1519d" mit den vier Teilen 19a, 19b, 19c, 19d der Zylinderplatte 19 verbunden. Die Verbindung erfolgt in ähnlicher Weise, wie die Verbindung der Zylinderplatte 19 mit dem Oberteil. Die Stifte 1519a, 1519a', 1519a", 1519b, 1519b', 1519b", 1519c, 1519c', 1519c", 1519d, 1519d', 1519d" sind nämlich an der Zylinderplatte 19 befestigt und ragen in die Langlöcher 155a, 155a' und 155a", 155b, 155b' und 155b", 155c, 155c' und 155c", 155d, 155d' und 155d" der Stempelplatte 15.

Somit ist jedes Teil 19a, 19b, 19c, 19d an drei seiner Ecken mit der Stempelführungsplatte verbunden. Lediglich die Ecken an dem Stoßpunkt A weisen keine Langlöcher auf.

Die Stifte 1519a bis 1519d" sind in den Langlöchern 155a, 155a' und 155a" der Stempelführungsplatte 15 angeordnet, die so ausgerichtet sind, dass Ihre Längsachsen sich in einem Stempelplattennullpunkt B1, B2, B3 oder B4 schneiden. Im kalten Zustand entsprechen diese Punkte B1, B2, B3, B4 jeweils dem Mittelpunkt der Teile 19a, 19b, 19c, 19d der Zylinderplatte 19. Die Anordnung der Langlöcher 155a, 155a' und 155a" und Stifte 1519a bis 1519d" der Stempelführungsplatte 15 ermöglicht dabei eine hervorragende Kompensation der unterschiedlichen Wärmedehnungen zwischen Zylinderplatte 19 (den vier Teilen 19a, 19b, 19c, 19d) und der Stempelführungsplatte 15. Aufgrund der Bestimmung der Nullpunkte B1, B2, B3, B4 der Stempelführungsplatte 15 ist nämlich sichergestellt, dass sich die Nullpunkte trotz der Wärmedehnung relativ zu ihrem entsprechenden Punkt der oberhalb der Stempelplatte 15 angeordneten Zylinderplatte 19 nicht verschieben. Dadurch ist unabhängig von der Wärmedehnung jederzeit eine exakte Druckausübung auf den Stempel 11 möglich. Dieser ist bevorzugt nämlich so angeordnet, dass einer der Stempelplattennullpunkte B1, B2, B3 oder B4 auf der Mittelachse des Stempels 11 liegt.

Somit ist jederzeit sichergestellt, dass auch bei einer Wärmedehnung der einzelnen Platten 15, 19 während des Betriebs der Vorrichtung die Stempel 11 immer hinreichend genau auf die Bauteile auf dem Substrat wirken, wodurch Fehlerzeugnisse vermieden werden können.

In der vorstehend beschriebenen Ausführungsform sind die Löcher so als Langlöcher ausgebildet, dass ein Nullpunkt oder ein Stempelplattennullpunkt einem Mittelpunkt der Platte oder eines Plattenteils einer mehrteiligen Platte entspricht.

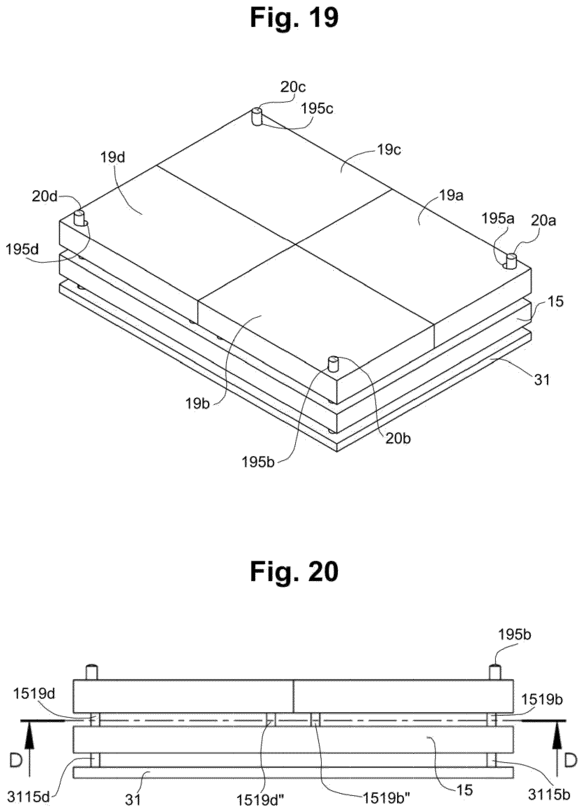

Figur 19 zeigt eine perspektivische Anordnung einer geteilten Zylinderplatte, einer Stempelplatte und eines Gegenstempels gemäß einer Ausführungsform der Erfindung. Figur 20 zeigt eine Ansicht der Anordnung der Figur 19 von vorne. Figur 21 zeigt eine Ansicht auf die Zylinderplatte der Figur 19 von der Stempelplatte aus gesehen entsprechend der Linie D-D in der Figur 20. Figur 22 zeigt eine Schnittansicht der Anordnung der Figur 19.

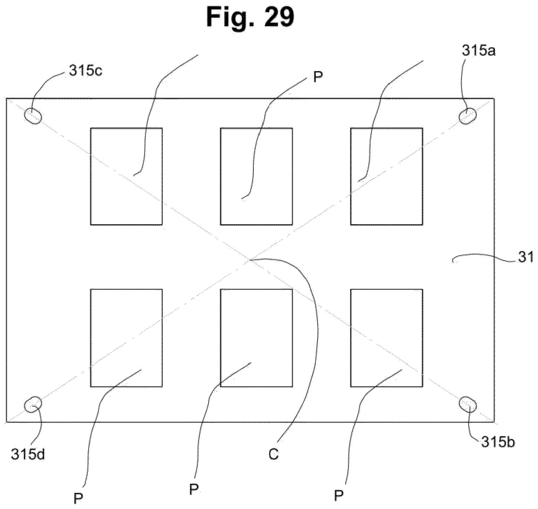

Die Ansicht der Figur 19 entspricht derjenigen der Figur 15, ist aber um einen Gegenstempel ergänzt, der als Produktträger dient. Eine Draufsicht des Produktträgers ist aus der Figur 29 ersichtlich.

Wie aus der Figur 19 ersichtlich ist, sind die mehrteilige Zylinderplatte 19, die Stempelplatte 15 und der Produktträger 31 in dieser Reihenfolge von oben nach unten angeordnet. Die Zylinderplatte 19 ist über die Stifte 20a, 20b, 20c und 20d an dem Oberteil 1 (siehe z. B. die Figur 1) der Vorrichtung zum Verbinden eines Bauelements mit einem Substrat angebracht, wie voranstehend beschrieben wurde.

An der Zylinderplatte 19 sind Stifte 1519a, 1519a', 1519a", 1519b, 1519b', 1519b", 1519c, 1519c', 1519c", 1519d, 1519d', 1519d" befestigt, wie bereits anhand der Figur 18 beschrieben wurde und aus der Figur 21 ersichtlich ist, die eine Unteransicht der Zylinderplatte 19 zeigt. Die nach unten ragenden Enden der Stifte 1519a, 1519a', 1519a", 1519b, 1519b', 1519b", 1519c, 1519c', 1519c", 1519d, 1519d', 1519d" sind in Langlöchern 155a, 155a', 155a", 155b, 155b', 155b", 155c, 155c', 155c", 155d', 155d" der Stempelplatte 15 aufgenommen und dienen dazu, die Stempelplatte bei einer Wärmedehnung zu führen.

Die Stempelplatte 15 wiederrum ist an ihrer Unterseite mit Stiften 3115a, 3115b, 3115c und 3115d versehen, deren nach unten ragende Enden wiederum bei geschlossener Kammer in Langlöchern 315a, 315b, 315c und 315d des Produktträgers (Gegenstempel 31) ragen, um dessen Ausdehnung bei einer Wärmedehnung zu führen. Auch die Langlöcher 315a, 315b, 315c und 315d sind so angeordnet, dass ihre Längsachsen sich in einem Gegenstempelnullpunkt C schneiden. Somit ist sichergestellt, dass der Gegenstempelnullpunkt C trotz Wärmedehnung an Ort und Stelle verbleibt, während sich die in der Figur 29 durch Rechtecke dargestellten Produkte P bei Erwärmung während des Prozesses entsprechend der Wärmedehnung mitverschieben.

Aufgrund der definierten Stempelplattennullpunkte B, B1, B2, B3, B4 ist aber sichergestellt, dass diese von den Produkten im Rahmen der Wärmedehnung erreichten Positionen von den Stempeln 11 ausreichend abgedeckt sind, um mit einer vorgesehenen Druckkraft beaufschlagt zu werden.

Während die Erfindung voranstehend anhand von einer derzeit bevorzugten Ausführungsform beschrieben wurde, ist festzuhalten, dass Alternativen hinsichtlich der Lage der Löcher und der Stifte möglich sind.

Beispielsweise ist der Nullpunkt, den die Langlöcher mit den Zylinderstiften definieren, frei wählbar. Während er gemäß Ausführungsform in der Mitte der Zylinderplatte liegt, kann er auch an anderer Stelle definiert sein, falls dies erforderlich ist.

Dies wird einfach erreicht, indem die Ausrichtung der Langlöcher geändert wird, dass sie sich ihre Längsachsen an einer anderen Stelle schneiden. Es kann nämlich bei manchen Anwendungen sinnvoll sein, den Nullpunkt des Werkzeugs an einen bestimmten Punkt des zu pressenden Bauteils zu setzen. In diesem Fall liegen die Längsachsen der Langlöcher nicht auf einer eine Ecke mit dem Mittelpunkt der Zylinderplatte verbindenden Linie.

In der Ausführungsform sind die Stifte und Löcher als Langlöcher in der Ecke der Zylinderplatte angeordnet. Es kann aber sinnvoll sein, diese auch an andere Stelle im Randbereich der Zylinderplatte anzuordnen, z. B. in der Mitte jeder Seite oder auch mehrere Löcher an jeder Seite der Zylinderplatte.

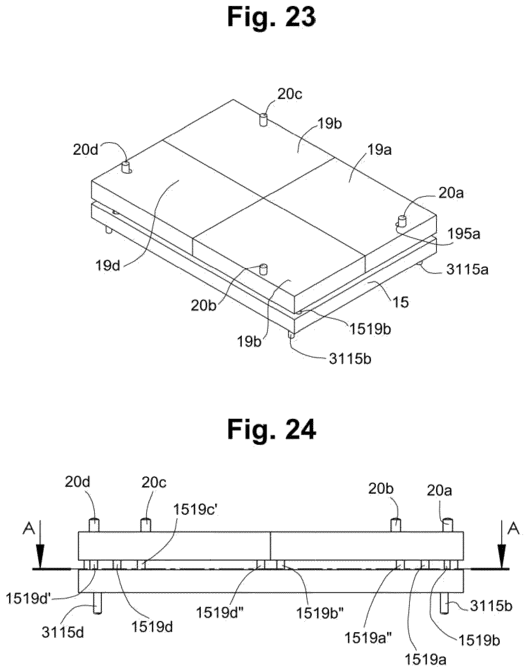

In der folgenden Beschreibung sind anhand der Figuren 23 bis 28 Alternativen betreffend die Anordnung der Löcher dargestellt. Zwar sind die Löcher auch als Langlöcher ausgebildet, aber die Nullpunkte der Zylinderplatte 19 und/oder der Stempelplatte 15 können an einer beliebigen von einem Mittelpunkt abweichenden Stelle auf der Platte oder dem Plattenteil definiert sein. Dies wird durch Drehen der Langlöcher und/oder Ändern der Position der Langlöcher derart erreicht, dass deren Längsachsen sich an der Stelle des vorgesehenen Nullpunkts schneiden.

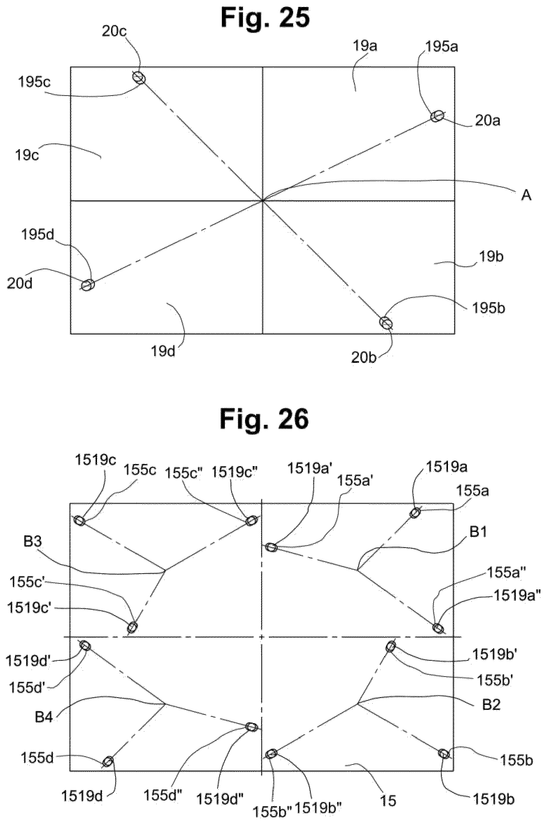

Gemäß der Figur 25 sind die Langlöcher 195a, 195b, 195c, 195d von den Ecken der Zylinderplatte 19 entlang des Randes verschoben. Dabei sind sie aber nach wie vor so ausgerichtet, dass ihre Längsachsen sich in einem Nullpunkt A schneiden, der dem Mittelpunkt der Zylinderplatte 19 und dem Stoßpunkt der vier Teilplatten 19a, 19b, 19c, 19d entspricht.

Die Langlöcher 155a, 155a', 155a'', 155b, 155b', 155b'', 155c, 155c', 155c'', 155d', 155d'' in der in Figur 26 abgebildeten Stempelplatte sind aber derart gedreht, dass ihre Längsachsen sich an einem Stempelplattennullpunkt B1, B2, B3, B4 schneiden, der nicht mit dem Mittelpunkt der virtuellen Teilplatten der Stempelplatte 15 zusammenfällt. Die Stifte 1519a, 1519a', 1519a'', 1519b, 1519b', 1519b'', 1519c, 1519c', 1519c'', 1519d, 1519d', 1519d'' sind an entsprechender Position an der Unterseite der Zylinderplatte 19 befestigt.

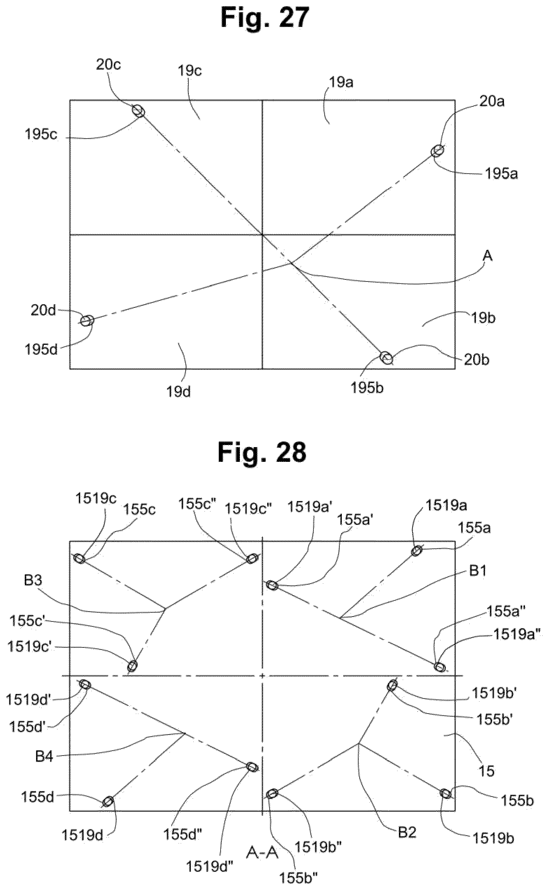

Aus den Figuren 27 und 28 sind weitere alternative Ausgestaltungen der Zylinderplatte 19 und der Stempelplatte 15 ersichtlich, in denen die Nullpunkte ebenfalls nicht mit dem Mittelpunkt der Platten oder Teilplatten zusammenfallen. Es wird noch darauf hingewiesen, dass anstelle der beschriebenen Stifte andere geeignete Führungselemente verwendet werden können. Als Beispiel dafür seinen Passfedern genannt.

**Patentansprüche**

1. Vorrichtung zum Verbinden eines Bauelements mit einem Substrat, mit einer in zumindest zwei Teile teilbaren Kammer, wobei

   an einem ersten Teil (1) ein Stempel (11, 111) vorgesehen ist, und
   an einem zweiten Teil (3) ein Gegenstempel (31) vorgesehen ist, und

   an einer von dem ersten Teil (1) abgewandten Seite des Gegenstempels (31) eine Heizeinrichtung (33) vorgesehen ist, wobei
   das erste Teil (1) in Richtung des zweiten Teils (3) verschiebbar ist, um die Kammer zu schließen, wobei

   der Gegenstempel (31) in einem geöffneten Zustand der Kammer mit Ausgangsstoffen beschickbar ist, und
   in einem geschlossenen Zustand der Kammer über den Stempel (11, 111) ein Druck auf die zwischen dem Stempel (11, 111) und dem Gegenstempel (31) vorgesehenen Ausgangsstoffe ausübbar ist, **dadurch gekennzeichnet, dass** der Gegenstempel (31) in einem unbelasteten Zustand von der Heizeinrichtung (33) beabstandet ist und konfiguriert ist, aufgrund des von dem Stempel (11, 111) ausgeübten Drucks gegen die Heizeinrichtung (33) in Anlage zu geraten.

2. Vorrichtung nach Anspruch 1, wobei
   die Heizeinrichtung (33) in Form einer Heizplatte ausgebildet ist, deren zu dem Gegenstempel (31) gerichtete Oberfläche konfiguriert ist, flächig mit einer von dem ersten Teil (1) abgewandten Oberfläche des Gegenstempels in Anlage zu geraten.

3. Vorrichtung nach Anspruch 1 oder 2, wobei
   der Gegenstempel (31) mittels Vorspannelementen von der Heizeinrichtung beabstandet ist, deren Vorspannung aufgrund des durch den Stempel (11, 111) ausgeübten Drucks überwunden wird und nach Beendigung der Druckausübung durch den Stempel (11, 111) wiederhergestellt wird.

4. Vorrichtung nach einem der Ansprüche 1 bis 3, wobei
   der Gegenstempel (31) in einem belastungsfreien Zustand mittels Federn (32) von der Heizeinrichtung (33) beabstandet ist.

5. Vorrichtung nach einem der Ansprüche 1 bis 4, wobei
   der Gegenstempel (31) in einem belastungsfreien Zustand mittels eines Luftkissens von der Heizeinrichtung (33) beabstandet ist, wobei die Luftzufuhr zu dem Luftkissen über zumindest teilweise durch die Heizeinrichtung geführte Luftkanäle (34, 36) erfolgt.

6. Vorrichtung zum Verbinden eines Bauelements mit einem Substrat, mit einer in zumindest zwei Teile teilbaren Kammer, wobei

   an einem ersten Teil (1) ein Stempel (11, 111) vorgesehen ist, und
   an einem zweiten Teil (3) ein Gegenstempel (31) vorgesehen ist, wobei
   das erste Teil (1) in Richtung des zweiten Teils (3) verschiebbar ist, um die Kammer zu schließen, wobei
   der Gegenstempel (31) in einem geöffneten Zustand der Kammer mit Ausgangsstoffen beschickbar ist, und

in einem geschlossenen Zustand der Kammer über den Stempel (11, 111) ein Druck auf die zwischen dem Stempel (11, 111) und dem Gegenstempel (31) vorgesehenen Ausgangsstoffe ausübbar ist, **dadurch gekennzeichnet, dass** ein Schaft (111) des Stempels (11, 111) in einer an dem ersten Teil (1) vorgesehenen Stempelführungsplatte (15) mittels Spielpassung mit Übermaß aufgenommen ist, und

ein Druckkörper (11) des Stempels (11, 111) eine größere Querschnittsfläche als der Schaft (11) des Stempels (11, 111) aufweist, wobei eine Unterdruckeinrichtung (119) an einer von dem Gegenstempel (31) abgewandten Seite der Stempelführungsplatte (15) bereitgestellt ist.

7. Vorrichtung nach Anspruch 6, wobei an der von dem Gegenstempel (31) abgewandten Seite der Stempelführungsplatte (15) eine Zylinderplatte (19) bereitgestellt ist, die einen in einer Zylinderbohrung hin- und herbeweglichen Kolben (117) aufweist, der an einer zu dem Stempel (11, 111) gerichteten Seite eine Führungsstange (113) aufweist, die konfiguriert ist, bei Druckbeaufschlagung des Kolbens (117) gegen die Stirnfläche des Schafts (111) in Anlage zu geraten und Druck auf den Stempel (11, 111) auszuüben.

8. Vorrichtung nach Anspruch 7, wobei

die Stirnfläche des Schafts (111) des Stempels (11, 111) plan ist, und

eine mit der Stirnfläche des Schafts (111) in Anlage zu bringende Spitze der Führungsstange (113) abgerundet ist.

9. Vorrichtung nach einem der Ansprüche 6 bis 8, wobei es sich bei der Unterdruckeinrichtung (119) um eine zwischen der Stempelführungsplatte (15) und einer an einer von dem Gegenstempel (31) abgewandten Seite der Stempelführungsplatte (15) vorgesehenen Zylinderplatte (19) ausgebildete Zwischensteuerkammer handelt, die mit einem Unterdruck oder einem Überdruck beaufschlagbar ist.

10. Vorrichtung nach einem der Ansprüche 7 bis 9, wobei in einer Rückzugsposition des Kolbens (117) und des Stempels (11, 111) zwischen der Spitze der Führungsstange (113) und der Stirnfläche des Schafts (111) des Stempels (11, 111) ein Abstand besteht.

**Claims**

1. A device for connecting a component to a substrate, comprising a chamber divisible into at least two parts, wherein

a punch (11, 111) is provided on a first part (1), and
a counter-punch (31) is provided on a second part (3), and a heating device (33) is provided on a side of the counter-punch (31) facing away from the first part (1), wherein
the first part (1) is shiftable toward the second part (3) to close the chamber, wherein
the counter-punch (31) can be loaded with raw materials when the chamber is open and, when the chamber is closed, pressure can be applied via the punch (11, 111) to the raw materials located between the punch (11, 111) and the counter-punch (31), **characterized in that** the counter-punch (31) is spaced apart from the heating device (33) in an unloaded state and is configured to come into contact with the heating device (33) due to the pressure exerted by the punch (11, 111).

2. The device according to claim 1, wherein the heating device (33) is designed as a heating plate, the surface of which facing the counter-stamp (31) is configured to get into contact over its entire surface with a surface of the counter-stamp facing away from the first part (1).

3. The device according to claim 1 or 2, wherein the counter-punch (31) is spaced apart from the heating device by means of biasing elements, the bias of which is overcome due to the pressure exerted by the punch (11, 111) and is restored after the punch (11, 111) ceases to exert pressure.

4. The device according to any one of claims 1 to 3, wherein the counter-punch (31) is spaced apart from the heating device (33) by means of springs (32) in an unloaded state.

5. The device according to any one of claims 1 to 4, wherein the counter-punch (31) is spaced apart from the heating device (33) in an unloaded state by means of an air cushion, wherein the air supply to the air cushion is provided via air channels (34, 36) that are at least partially guided through the heating device.

6. A device for connecting a component to a substrate, comprising a chamber divisible into at least two parts, wherein

a punch (11, 111) is provided on a first part (1), and

a counter-punch (31) is provided on a second part (3), wherein

the first part (1) is shiftable toward the second part (3) to close the chamber, wherein

the counter-punch (31) can be loaded with raw materials when the chamber is open and, when the chamber is closed, pressure can be applied via the punch (11, 111) to the raw materials located between the punch (11, 111) and the counter-punch (31), **characterized in that** a shaft (111) of the punch (11, 111) is received in a punch guiding plate (15) provided on the first part (1) by means of a clearance fit with an oversize, and

a pressure body (11) of the punch (11, 111) has a larger cross-sectional area than the shaft (11) of the punch (11, 111), wherein

a vacuum device (119) is provided on a side of the punch guiding plate (15) facing away from the counter-punch (31).

7. The device according to claim 6, wherein a cylinder plate (19) is provided on the side of the punch guiding plate (15) facing away from the counter-punch (31) and comprises a piston (117) movable back and forth in a cylinder bore, said piston having, on a side facing the punch (11, 111), a guide rod (113) which is configured to come into contact with the end face of the shaft (111) when pressure is applied to the piston (117) and to exert pressure on the punch (11, 111).

8. The device according to claim 7, wherein

the end face of the shaft (111) of the punch (11, 111) is flat, and

a tip of the guide rod (113) intended to get into contact with the end face of the shaft (111) is rounded.

9. The device according to any one of claims 6 to 8, wherein the vacuum device (119) is an intermediate control chamber which is formed between the punch guiding plate (15) and a cylinder plate (19) provided on a side of the punch guiding plate (15) facing away from the counter-punch (31), and to which a negative pressure or a positive pressure can be applied.

10. The device according to any one of claims 7 to 9, wherein, in a retracted position of the piston (117) and the punch (11, 111), there is a gap between the tip of the guide rod (113) and the end face of the shaft (111) of the punch (11, 111).

**Revendications**

1. Dispositif pour relier un composant à un substrat, comprenant une chambre divisible en au moins deux parties,

   un poinçon (11, 111) étant prévu sur une première partie (1), et
   un contre-poinçon (31) étant prévu sur une deuxième partie (3), et

   un dispositif de chauffage (33) est prévu sur un côté du contre-poinçon (31) opposé à la première partie (1),

   la première partie (1) pouvant coulisser en direction de la deuxième partie (3) pour fermer la chambre,

   le contre-poinçon (31) pouvant être alimenté en matières premières lorsque la chambre est ouverte et,
   lorsque la chambre est fermée, une pression pouvant être exercée par le poinçon (11, 111) sur les matières premières prévues entre le poinçon (11, 111) et le contre-poinçon (31), **caractérisé en ce que**
   le contre-poinçon (31) est espacé du dispositif de chauffage (33) dans un état non chargé et est configuré pour venir en appui contre le dispositif de chauffage (33) sous l'effet de la pression exercée par le poinçon (11, 111).

2. Dispositif selon la revendication 1, dans lequel le dispositif de chauffage (33) se présente sous la forme d'une plaque chauffante dont la surface tournée vers le contre-poinçon (31) est configurée pour venir en appui sur toute sa surface avec une surface du contre-poinçon opposée à la première partie (1).

3. Dispositif selon la revendication 1 ou 2, dans lequel le contre-poinçon (31) est espacé du dispositif de chauffage au moyen d'éléments de sollicitation, dont la sollicitation est surmontée en raison de la pression exercée par le poinçon (11, 111) et est rétablie après la fin de l'exercice de la pression par le poinçon (11, 111).

4. Dispositif selon l'une des revendications 1 à 3, dans lequel
   le contre-poinçon (31) est espacé du dispositif de chauffage (33) au moyen de ressorts (32) lorsqu'il est à l'état non chargé.

5. Dispositif selon l'une des revendications 1 à 4, dans lequel
   le contre-poinçon (31) est espacé du dispositif de chauffage (33) au moyen d'un coussin d'air lorsqu'il est à l'état non chargé, l'alimentation en air du coussin d'air s'effectuant par l'intermédiaire de canaux d'air (34, 36) guidés au moins en partie à travers le dispositif de chauffage.

6. Dispositif pour relier un composant à un substrat, comprenant une chambre divisible en au moins deux parties,

   un poinçon (11, 111) étant prévu sur une première partie (1), et
   un contre-poinçon (31) étant prévu sur une deuxième partie (3), dans laquelle
   la première partie (1) pouvant coulisser en direction de la deuxième partie (3) pour fermer la chambre,
   le contre-poinçon (31) pouvant être alimenté en matières premières lorsque la chambre est ouverte et,
   lorsque la chambre est fermée, une pression pouvant être exercée, par l'intermédiaire du poinçon (11, 111) sur les matières premières prévues entre le poinçon (11, 111) et le contre-poinçon (31), **caractérisé en ce que**
   une tige (111) du poinçon (11, 111) est logée dans une plaque de guidage de poinçon (15) prévue sur la première partie (1) au moyen d'un ajustement avec jeu de façon surdimensionné, et
   un corps de pression (11) du poinçon (11, 111) présente une surface transversale plus grande que la tige (11) du poinçon (11, 111),
   un dispositif de dépression (119) étant fourni sur un côté de la plaque de guidage du poinçon (15) opposé au contre-poinçon (31).

7. Dispositif selon la revendication 6, dans lequel, sur le côté de la plaque de guidage du poinçon (15) opposé au contre-poinçon (31), est fournie une plaque de cylindre (19) comportant un piston (117) mobile en va-et-vient dans un alésage de cylindre, lequel piston comportant, sur un côté tourné vers le poinçon (11, 111) une tige de guidage (113) qui est configurée, lorsque le piston (117) est mis sous pression, pour venir en appui contre la face frontale de la tige (111) et pour exercer une pression sur le poinçon (11, 111).

8. Dispositif selon la revendication 7, dans lequel

   la face frontale de la tige (111) du poinçon (11, 111) est plane, et
   une pointe de la tige de guidage (113), destinée à venir en appui contre la face frontale de la tige (111), est arrondie.

9. Dispositif selon l'une des revendications 6 à 8, dans lequel le dispositif de dépression (119) est une chambre de commande intermédiaire qui est formée entre la plaque de guidage du poinçon (15) et une plaque cylindrique (19) prévue sur un côté de la plaque de guidage du poinçon (15) opposé au contre-poinçon (31) et qui peut être soumise à une dépression ou à une surpression.

10. Dispositif selon l'une des revendications 7 à 9, dans lequel, dans une position de retrait du piston (117) et du poinçon (11, 111), il existe un écart entre la pointe de la tige de guidage (113) et la face frontale de la tige (111) du poinçon (11, 111).

Fig. 1

Fig. 2a

Fig. 2b

EP 4 525 032 B1

Fig. 3a

Fig. 3b

Fig. 4a          Fig. 4b

EP 4 525 032 B1

Fig. 5

Fig. 6

11

Fig. 7a

15 111

Fig. 7b

11

111

Fig. 7c

Fig. 8

Fig. 9

EP 4 525 032 B1

Fig. 10

# Fig. 11

# Fig. 12

A-A

Fig. 13

Fig. 14

## Fig. 15

# Fig. 16

# Fig. 17

# Fig. 18

A-A

# Fig. 19

# Fig. 20

# Fig. 21

D-D

# Fig. 22

E-E

# Fig. 23

# Fig. 24

# Fig. 25

# Fig. 26

# Fig. 27

# Fig. 28

# Fig. 29

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2022020710 A1
- DE 102013101124
- DE 102015120156 A1